# EUROPEAN PATENT SPECIFICATION

(11) **EP 4 178 326 B1**
(45) Date of publication and mention of the grant of the patent: **25.03.2026**
(21) Application number: 22205647.5
(22) Date of filing: 04.11.2022
(51) Int. Cl.: H05K 3/12, B41F 16/00

(54) **PATTERN TRANSFER PRINTING SYSTEM AND METHOD**
SYSTEM UND VERFAHREN ZUM TRANSFERDRUCK DURCH MUSTERÜBERTRAGUNG
SYSTÈME ET PROCÉDÉ D'IMPRESSION PAR TRANSFERT DE MOTIF

(30) Priority: 09.11.2021 CN 202111321391; 09.11.2021 CN 202122732445 U; 19.01.2022 IL 29019422; 25.01.2022 US 202217583440
(43) Date of publication of application: 10.05.2023
(73) Proprietor: Wuhan Dr Laser Technology Corp., Ltd., Wuhan 430223 (CN)
(72) Inventor: IGRA, Gad, 7405845 9 Nachmias Shmuel St., Ness Ziona (IL); COHEN, Eyal, 4420801 1 Keren Avraham St., Kfar-Saba (IL); YUNGER, Eran, 8548000 Meshek 66, Moshav Sdei Avraham (IL); FINAROV, Moshe, 7647013 16/7 Einstein Street, Rechovot (IL); XU, Tao, No. 5, Road 2 Hushi Park, East Lake high tech development zone, Wuhan, 430223 (CN); SHI, Jing, No. 5, Road 2 Hushi Park, East Lake high tech development zone, Wuhan, 430223 (CN); TONG, Weiguo, No. 5, Road 2 Hushi Park, East Lake high tech development zone, Wuhan, 430223 (CN); LI, Zhigang, No. 5, Road 2 Hushi Park, East Lake high tech development zone, Wuhan, 430223 (CN)
(74) Representative: Pearl Cohen UK

(56) References cited:
- WO-A1-2018/020479
- US-A1- 2009 074 987
- US-A1- 2011 097 550
- US-A1- 2017 013 724

## Description

### BACKGROUND OF THE INVENTION

### 1. TECHNICAL FIELD

The present invention relates to the field of pattern transfer printing, and more particularly, to producing photovoltaic cells.

### 2. DISCUSSION OF RELATED ART

U.S. Patent Application Publication No. 2017/013724 teaches an apparatus for generating a transfer pattern to be used in a transfer printing process. The pattern is generated in a substrate that could be a web substrate and that bears one or more trenches. A filler, e.g., high viscosity metal paste, to be transferred is made to fill the trenches within the web substrate. Upon completion of the trench of the substrate filled with filler, the filling head, which may include a scraper and a squeegee, is translated from the working zone in a synchronized movement, such that in course of the translation movement the filling head remains in full contact with the substrate.

US. Patent Application Publication No. 2011/097550 discloses a source or target substrate carrying a patterned coating thereon, a receiving substrate and a light source adapted to radiate a light beam to the source substrate, thereby depositing the patterned coating from the source substrate onto the receiving substrate.

Lossen et al. (2015), Pattern Transfer Printing (PTP™) for c-Si solar cell metallization, 5th Workshop on Metallization for Crystalline Silicon Solar Cells, Energy Procedia 67:156-162 teaches pattern transfer printing (PTP^{™}) as a non-contact printing technology for advanced front side metallization of c-Si PV solar cells, which is based on laser-induced deposition from a polymer substrate.

### SUMMARY OF THE INVENTION

One aspect of the present invention provides a pattern transfer printing (PTP) system according to claim 1, namely a pattern transfer printing (PTP) system comprising:
a tape handling unit configured to handle a tape comprising, as sections thereof, a plurality of pattern transfer sheets having respective patterns of trenches, and to controllably deliver the pattern transfer sheets for paste filling and consecutively for pattern transfer,a paste filling unit configured to fill the trenches on the delivered pattern transfer sheets with conductive printing paste, a wafer handling unit configured to controllably deliver at least one wafer for the pattern transfer at a close proximity to the pattern transfer sheet, a paste transfer unit configured to transfer the conductive printing paste from the pattern transfer sheets filled with the conductive printing paste onto the wafer delivered in position, by releasing the conductive printing paste from the trenches upon illumination by a laser beam,
wherein the tape handling unit is configured to move the tape from an unwinder roll to a rewinding roll in a step-and-repeat mode,
and wherein the pattern transfer printing (PTP) system further comprises:
   a trench alignment monitoring unit configured to monitor a position and a distortion of the trenches prior to the pattern transfer.

Another aspect of the present invention provides a pattern transfer printing (PTP) method according to claim 13, namely a pattern transfer printing (PTP) method comprising: handling a tape comprising, as sections thereof, a plurality of pattern transfer sheets having respective patterns of trenches, to controllably deliver the pattern transfer sheets for paste filling and consecutively for pattern transfer, filling the trenches on the delivered pattern transfer sheets with conductive printing paste, controllably delivering a plurality of wafers for the pattern transfer, and monitoring positions and distortions of the trenches prior to the pattern transfer, transferring the conductive printing paste from the pattern transfer sheets onto the delivered wafers, by releasing the printing paste from the trenches upon illumination by a laser beam, wherein the handling of the tape comprises moving the tape from an unwinder roll to a rewinding roll in a step-and-repeat mode, and optionally comprising at least one of: monitoring a tension and a position of the tape, cleaning the pattern transfer sheets after the pattern transfer to provide reusable pattern transfer sheets, supporting a back side of the pattern transfer sheet by a countering moveable roll during the paste filling, affixing and flattening the pattern transfer sheet during the pattern transfer,detecting and measuring features on the wafer and adjusting accordingly the transferring of the conductive printing paste from the pattern transfer sheets onto the delivered wafers, and inspecting a quality of the transferred paste pattern.

These, additional features and/or advantages of the present invention are set forth in the detailed description which follows.

### BRIEF DESCRIPTION OF THE DRAWINGS

For a better understanding of embodiments of the invention and to show how the same may be carried into effect, reference will now be made, purely by way of example, to the accompanying drawings in which like numerals designate corresponding elements or sections throughout.

In the accompanying drawings:
**Figure 1A** is a high-level schematic illustration of a pattern transfer printing (PTP) system, according to some embodiments of the invention.
**Figures 1B** and **1C** are high-level schematic illustrations of maintenance options and arrangements of PTP systems in a dual-lane production line, according to some embodiments of the invention.
**Figures 2A** and **2B** are high-level schematic side view and front view illustrations, respectively, of units and elements in PTP systems, according to some embodiments of the invention.
**Figure 3A** is a high-level schematic side view illustration of a tape handling unit, according to some embodiments of the invention.
**Figures 3B-3E** are high-level schematic illustrations of tapes with pattern transfer sheets and of the pattern transfer stage, according to some embodiments of the invention.
**Figure 4** is a high-level schematic illustration of a tape re-use unit, according to some embodiments of the invention.
**Figures 5A** and **5B** are high-level schematic illustrations of paste filling units, according to some embodiments of the invention.
**Figures 5C-5E** are high-level schematic illustrations of printing heads, according to some embodiments of the invention
**Figures 6A-6C** are high-level schematic illustrations of wafer handling units and of their operation, according to some embodiments of the invention.
**Figures 6D** and **6E** are high-level schematic illustrations of wafer measurement units, according to some embodiments of the invention.
**Figures 7A-7C** are high-level schematic illustrations of tape stretching units and trench alignment monitoring units, according to some embodiments of the invention.
**Figure 8** is a high-level schematic illustration of a print quality control unit, according to some embodiments of the invention.
**Figure 9A** is a high-level flowchart illustrating PTP methods, according to some embodiments of the invention.
**Figure 9B** is a high-level flowchart illustrating the parallel processes in the pattern transfer printing (PTP) method, according to some embodiments of the invention.
**Figure 10** is a high-level block diagram of exemplary computing device, which may be used with embodiments of the present invention.
It will be appreciated that for simplicity and clarity of illustration, elements shown in the figures have not necessarily been drawn to scale. For example, the dimensions of some of the elements may be exaggerated relative to other elements for clarity. Further, where considered appropriate, reference numerals may be repeated among the figures to indicate corresponding or analogous elements.

Beyond that, it is indicated that the terms: paste transfer unit, paste pattern transfer unit and pattern transfer unit are to be regarded as equivalents/synonyms in the following description.

### DETAILED DESCRIPTION OF THE INVENTION

Embodiments of the present invention provide efficient and economical methods and mechanisms for pattern transfer printing and thereby provide improvements to the technological field of producing electrical contacts, and specifically of producing photovoltaic cells. Pattern transfer printing (PTP) systems and methods are provided to improve the quality, accuracy and throughput of pattern transfer printing. PTP systems comprise a tape handling unit for handling a tape with pattern transfer sheets and for controllably delivering the pattern transfer sheets one-by-one for paste filling and consecutively for pattern transfer, with the tape moving from an unwinder roll to a rewinding roll. PTP systems further comprise a paste filling unit which enables continuous paste filling using a supporting counter roll opposite to the paste filling head, a wafer handling unit controllably delivering wafers for the pattern transfer in a parallelized manner that increases throughput, a paste transfer unit with enhanced accuracy and efficiency due to exact monitoring and wafer alignment, as well as a print quality control. The PTP system may be configured to be used in a dual lane configuration with two parallel wafer flows so that the tape and the paste replacement and maintenance in each system are accessible from their front sides.

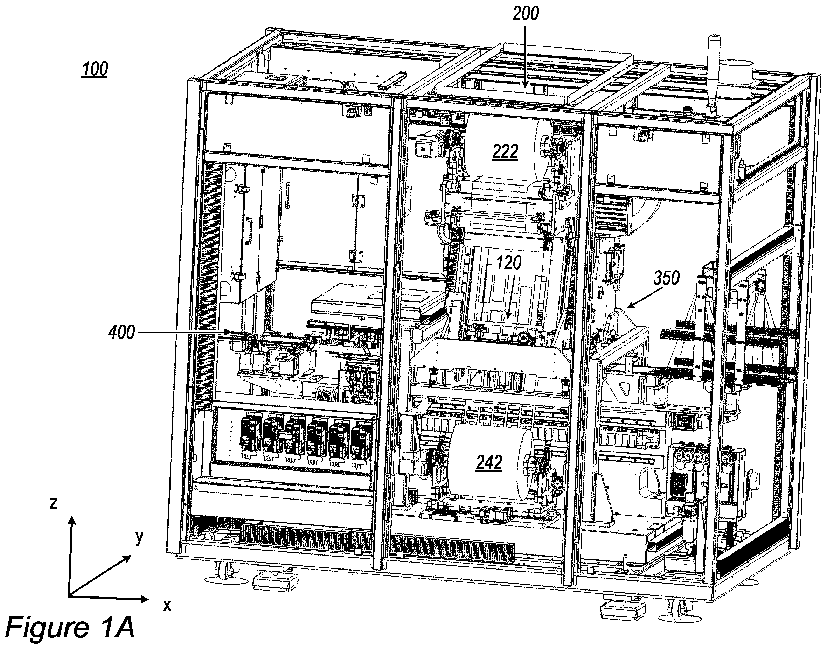

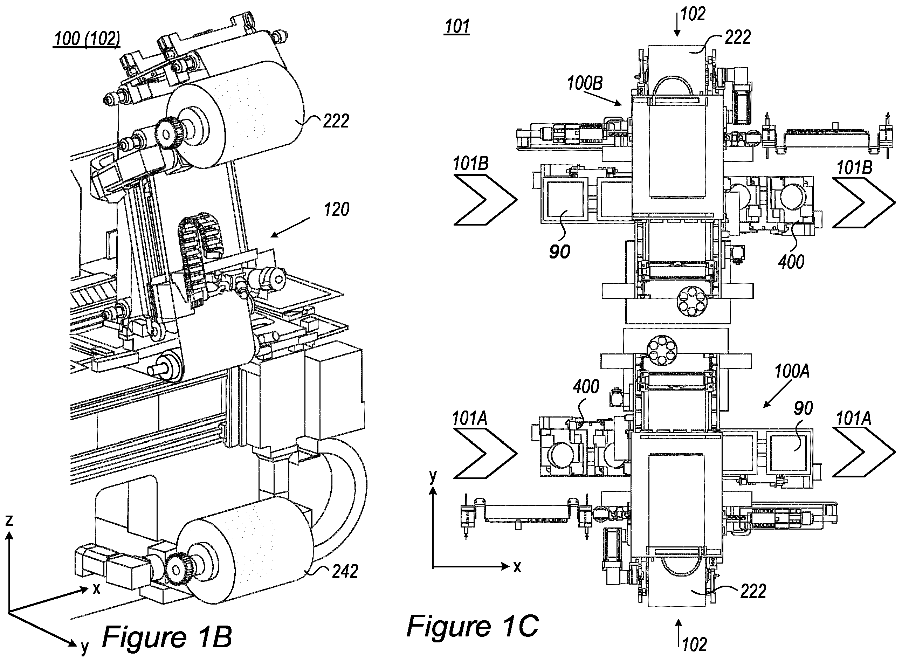

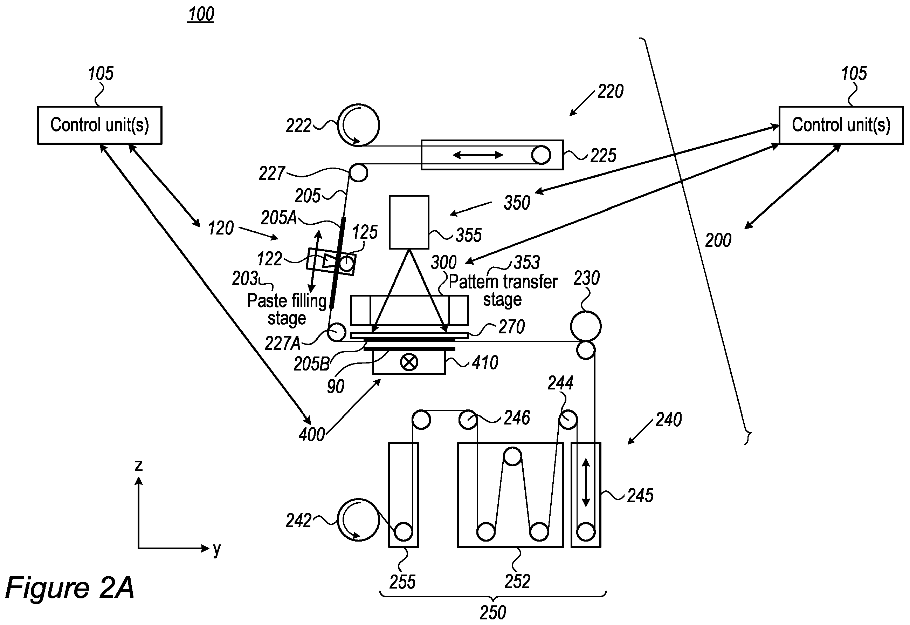

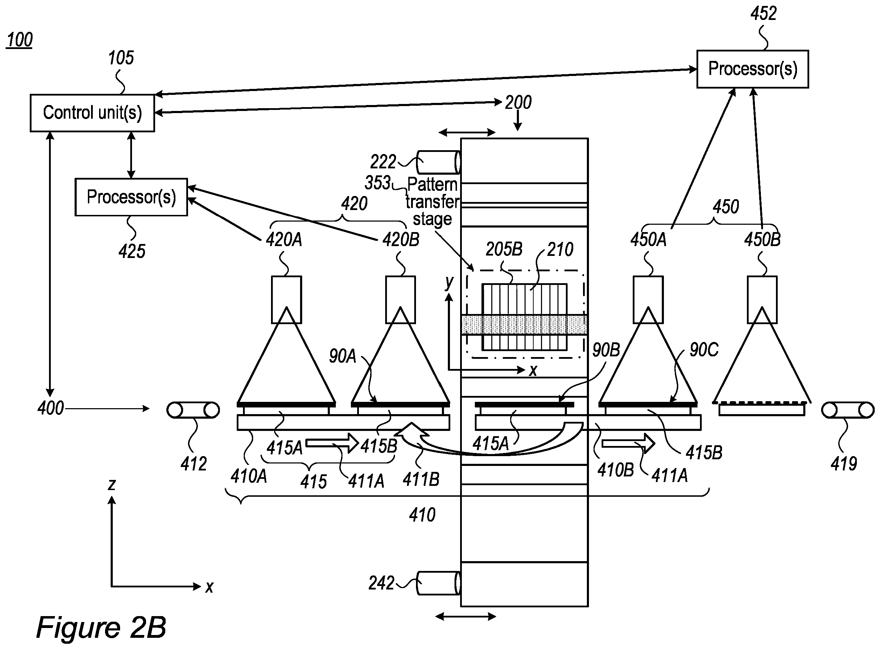

**Figure 1A** is a high-level schematic illustration of a pattern transfer printing (PTP) system **100,** according to some embodiments of the invention. **Figures 1B** and **1C** are high-level schematic illustrations of maintenance options and arrangements of PTP systems **100** in a dual-lane production line **101,** according to some embodiments of the invention. **Figure 1A** is a schematic perspective front view of PTP system **100,** **Figure 1B** is a schematic perspective view of a front side **102** of PTP system **100,** made accessible for easy maintenance, and **Figure 1C** is a schematic top view of PTP systems **100** arranged in a dual-lane production line **101.** **Figures 2A** and **2B** are high-level schematic side view and front view illustrations, respectively, of units and elements in PTP systems **100,** according to some embodiments of the invention. The highly schematic side view illustration of **Figure 2A** provides a non-limiting example for the arrangement of elements in tape handling unit **200** with respect to paste filling unit **120** (carrying out a paste filling stage **203**) and paste transfer unit **350** (carrying out a pattern transfer stage **353,** see, e.g., in **Figures 2A** and **2B**), while the highly schematic front view illustration of **Figure 2B** provides a non-limiting example for the arrangement of elements in wafer handling unit **400** and with respect to tape handling unit **200.** Units and elements illustrated in **Figures 2A** and **2B** are described briefly below, with more details of non-limiting embodiments providing in the consecutive figures. One or more control units **105** (see, e.g., in **Figures 2A** and **2B**), may be configured to monitor and/or control the units of PTP system **100,** possibly via various processors, and coordinate the operation of PTP system **100.**

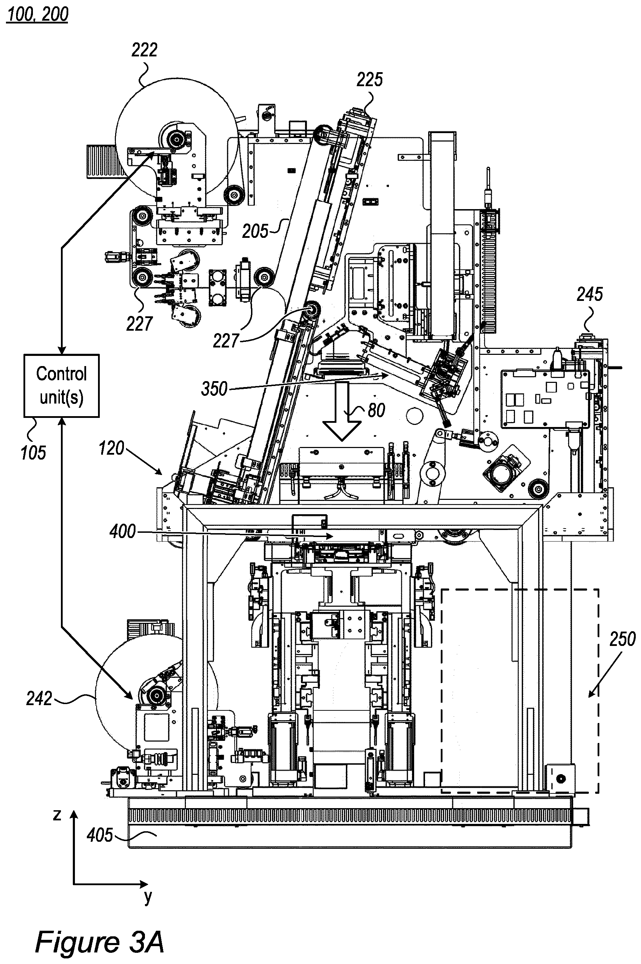

PTP system **100** is configured to apply patterns of conductive material onto wafers by non-contact printing. PTP system **100** comprises a tape handling unit **200** configured to handle a tape **205** (see, e.g., **Figure 2A**) comprising, as sections thereof, a plurality of pattern transfer sheets **205A, 205B** (see, e.g., **Figure 2A**) having respective patterns of trenches, and to controllably deliver pattern transfer sheets for paste filling **205A** and consecutively for pattern transfer **205B,** respectively. Tape handling unit **200** is configured to move tape **205** in a step-and-repeat manner (sheet by sheet) from an unwinder roll **222** to a re-winding roll **242.** PTP system **100** further comprises a paste filling unit **120** configured to fill the trenches on delivered pattern transfer sheets **205A** with conductive printing paste. Tape handling unit **200** may be further configured to deliver the pattern transfer sheets one-by-one for the paste filling (denoted sheets **205A**) and/or for the pattern transfer (denoted sheets **205B**) with continuous monitoring of the tension and the Machine Direction (MD, along the tape movement) and Cross Machine Direction (CMD, perpendicularly to MD) positions of tape **205.** PTP system **100** further comprises a wafer handling unit **400** configured to controllably deliver a plurality of wafers **90** (see, e.g., **Figure 2B**) for the pattern transfer, at a close proximity (e.g., in a range of between 0.1mm and 0.5mm) to the pattern transfer sheet. The PTP system **100** further comprises a paste transfer unit **350** configured to transfer the conductive printing paste from respective pattern transfer sheet **205B** onto respective delivered wafer **90B,** by releasing the printing paste from the trenches upon illumination by a laser beam **80** (illustrated, e.g., in **Figure 3A**).

The units of PTP system **100** are mounted on a rigid frame in a compact manner, to minimize the system's footprint. As a general design feature, tape handling is carried out along a vertical direction (denoted "z") and along one horizontal direction (denoted "y", termed machine direction, MD), while wafer handling is carried out along a perpendicular direction thereto, e.g., in another horizontal direction (denoted "x", termed cross machine direction, CMD).

Tape handling unit **200** may be configured to deliver pattern transfer sheets one-by-one for the paste filling (e.g., pattern transfer sheet **205A**) - at a paste filling process stage **203,** by help of a moving paste filling head **122** - and/or for the pattern transfer (e.g., pattern transfer sheet **205B**) - in a paste pattern transfer unit carrying out paste transfer process stage **353,** by help of a movable scanner **355** (e.g., moveable along the x and y axes and optionally tiltable at an angle θ, or possibly an optical head that scans along the y axis, is moveable along the x axis and optionally tiltable at an angle θ), see, e.g., **Figure 2A****.** Details concerning tape **205** and pattern transfer sheets thereupon are provided below. It is noted that in **Figure 2B** pattern transfer sheet **205A** is illustrated schematically at the plane of the drawing as it is located in the paste filling unit **120** almost vertically. For example, paste filling unit **120** and pattern transfer sheet **205B** plane may be set at an angle deviating 0-30° from the vertical x-z plane.

In embodiments, one or more top dancer **225** and bottom dancer **245** (see, e.g., **Figure 2A**) may be configured to buffer the step-and-repeat movement of tape **205** from unwinder roll **222** and to re-winding roll **242,** respectively, as pattern transfer sheet **205A** is being filled with paste and/or as paste from pattern transfer sheet **205B** is being transferred, so as to ensure that these are carried out with the respective pattern transfer sheet in static positions. Top dancer(s) **225** and/or bottom dancer(s) **245** may be configured to maintain the tension in tape **205** moving through at least a part of PTP system **100.**

It is noted that in PTP system **100,** paste filling unit **120** is positioned almost vertically (along the z axis) to ensure a short travelling distance of pattern transfer sheet **205A** from paste filling to pattern transfer sheet **205B** at paste transfer unit **350** thus enabling to minimize changes of the filled paste condition (e.g., due to drying before printing) . For example, the near-vertical position may be configured to enable a smaller movement distance for the pattern transfer sheets from state **205A** to state **205B,** and thereby optionally to locate the laser scanner just behind the vertical filling unit, closer to roll **227A** positioned between **205A** and **205B,** illustrated schematically in **Figure 2A****.** The near-vertical position of paste filling unit **120** is advantageous with respect to prior art horizontal position of paste filling units, as it reduces the distance between the paste filling position **(205A)** and the paste transfer position **(205B)** of the pattern transfer sheet **205.**

As illustrated schematically in **Figure 1B****,** front side **102** of PTP system **100** may be configured to have unwinder roll **222** and re-winding roll **242** easily accessible for replacement and maintenance requirements, as well as have paste filling unit **120** easily accessible for paste filling and maintenance requirements - from same front side **102.** Moreover, as illustrated schematically in **Figure 1C****,** PTP systems **100** may be arranged back-to-back, in dual-lane production line **101,** with each of front sides **102** of PTP systems **100A, 100B** easily accessible for maintenance. Dual-lane production line **101** may be configured to include two lanes **101A, 101B,** each with one or more (serially arranged) PTP systems **100A, 100B,** which operate on two (or more) paths of wafers **90** (e.g., independent paths for higher throughput), using a relatively small footprint.

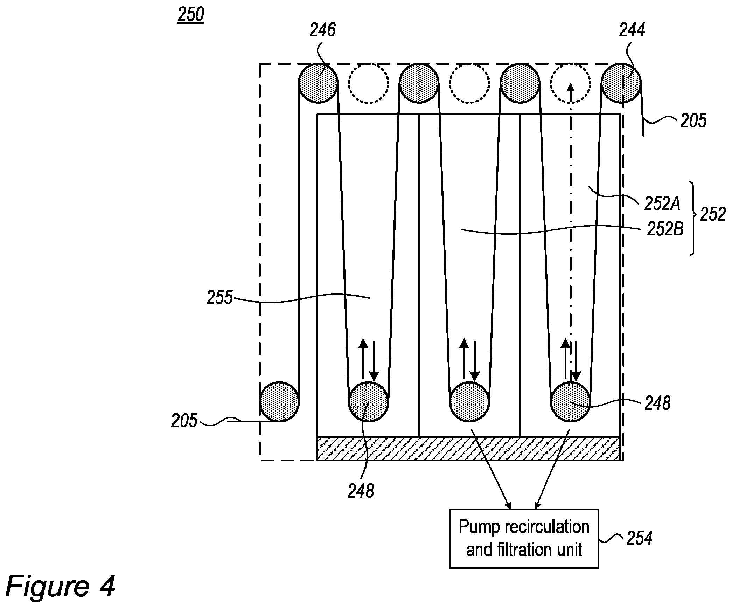

PTP system **100** may further comprise a tape re-use unit **250** (see, e.g., **Figure 2A**) configured to clean pattern transfer sheets after the pattern transfer to provide reusable pattern transfer sheets. For example, tape re-use unit **250** may comprise a tape cleaning unit **252** in which tape **205** may be cleaned mechanically, e.g., using scraper(s), ultrasound, and/or other means, and/or chemically using cleaning solutions; and a tape drying unit **255,** with idle rolls **244, 246** positioned as needed to maintain safe tape movements. Tape **205** may be moved by one or more tape drive motor(s) **230** (illustrated schematically), and further supported by one or more rolls **227** along the way of tape **205** through PTP system **100.** A non-limiting example for tape handling unit **200** is illustrated with more details in **Figures 3A-3E****.** A non-limiting example for tape re-use unit **250** is illustrated with more details in **Figure 4****.**

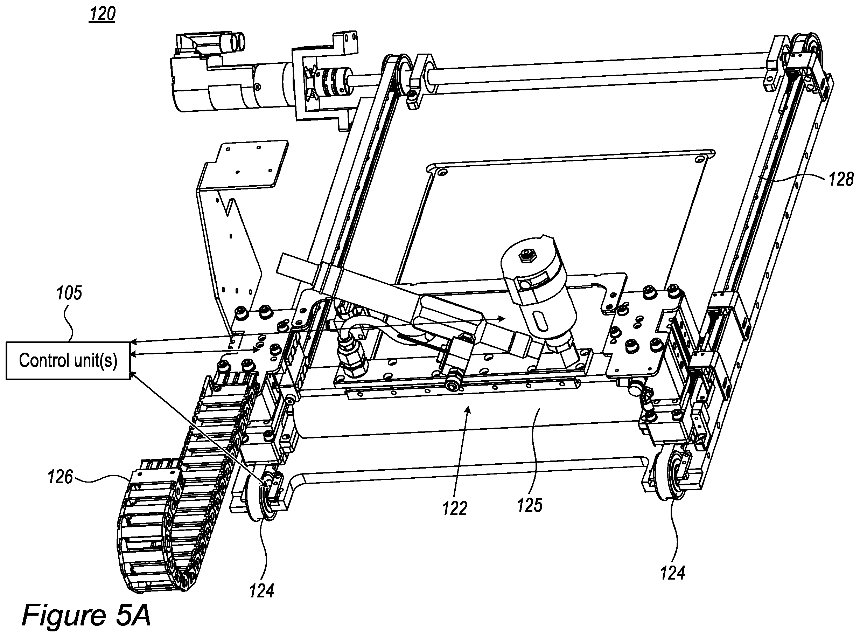

Paste filling unit **120** (see, e.g., **Figure 2A**) may comprise moveable paste filling head **122** and a countering moveable roll **125** configured to support a back side of pattern transfer sheet **205A** during the paste filling. A non-limiting example for paste filling unit **120** is illustrated with more details in **Figures 5A-5E****.**

In certain embodiments, wafer handling unit **400** may comprise at least one stage **410** enabling movement in x and z axes (termed in the following - the x,z-stage), with each stage **410** comprising at least one holder (e.g., chuck) **415,** and with each holder supporting wafer **90** and enabling wafer movement in y and θ axes (θ axis relates to rotation of a wafer with respect to the x-y plane). In certain embodiments, two x,z-stages **410** of wafer handling unit **400** may be configured to operate in parallel with respect to each other. Each stage **410** may comprise two holders **415** for holding wafers **90,** each holder **415** ensuring wafer movement in y, θ - axis thus enabling faster wafer handling and continuous wafers movement during pattern transfer. Multiple cameras imaging incoming wafers enable more accurate wafer alignment within the printing system thus more accurate alignment of printed conductive lines onto wafer pattern.

Wafer handling unit **400** (see, e.g., **Figure 2B**) may comprise two stages **410A, 410B,** with each stage **410** supporting two wafers **90**, e.g., via wafer holders **415A, 415B** (e.g., vacuum chucks). Each stage **410** may support at least one wafer holder (chuck) **415,** e.g., two or three holders (chucks) **415.** As a non-limiting example, two holders (chucks) **415A, 415B** for each of two stages **410A, 410B** are illustrated. Stages **410** may be configured to enable movement along the x and z axes, while each holder (chuck) **415** may be configured to support wafer **90** and enable additional wafer movement at least along the y and θ axes, as explained below.

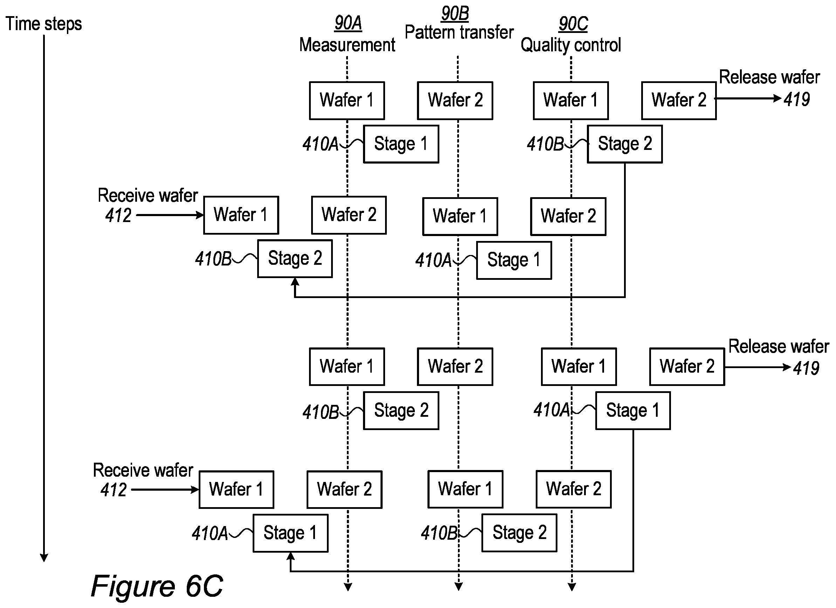

Wafer handling unit **400** may be configured to alternate two stages **410A, 410B** during operation to enable parallel operation on wafers **90** by different units of PTP system **100.** For example, the position of wafer **90A** may be measured by a wafer alignment unit **420** while wafer **90B** received transferred paste by paste transfer unit **350** and wafer **90C** is inspected by a print quality control unit **450,** as disclosed herein. During the alteration of stages **410,** two wafers **90** may be processed by respective units, increasing the overall throughput of PTP system **100.** For example, wafer handling unit **400** may be configured to provide simultaneous (i) wafer measurement of two wafers **90A** (first and second wafers, mounted on holders (chucks) **415A** and **415B** on stage **410A,** respectively), (ii) pattern transfer to a third wafer **90B** (mounted on holder (chuck) **415A** on stage **410B**) and (iii) print quality control of a fourth wafer **90C** (mounted on holder (chuck) **415B** on stage **410B).** Then, wafer handling unit **400** may be configured to move stages **410A, 410B** according to arrows **411A,** so that the wafers are move to the consecutive operations (e.g., wafer **90A** is moved from wafer measurement to pattern transfer, wafer **90B** is moved from pattern transfer to print quality control and wafer **90C** is moved out of the system, while a new wafer is moved to wafer measurement). Following the linear stage movements along CMD, stages **410A, 410B** may be switched (arrow **411B**), so that wafer **90** are further processed, and the movements repeat cyclically, as illustrated schematically in **Figure 6C**).

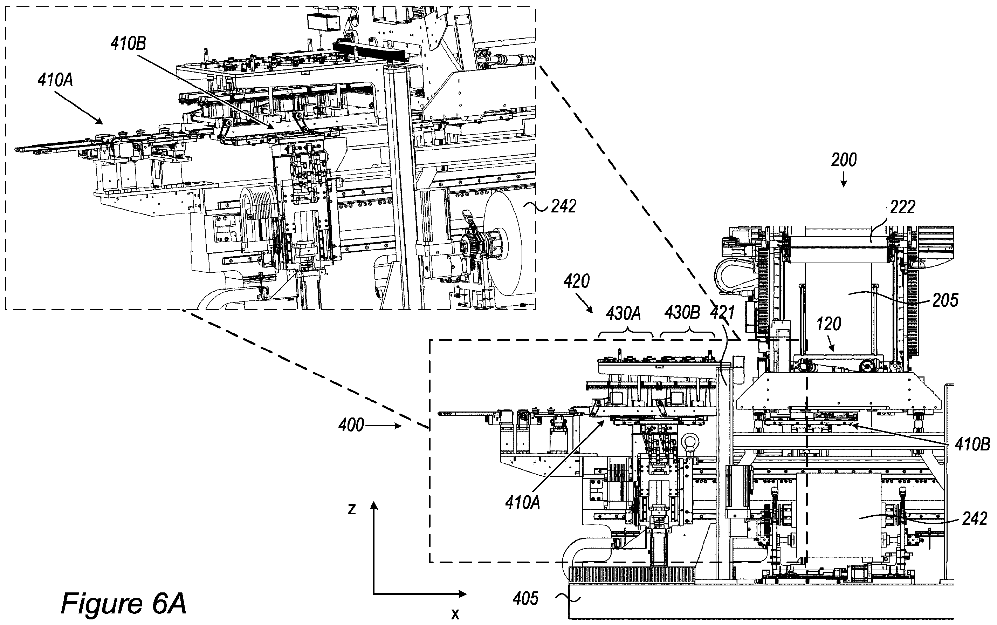

Wafer handling unit **400** may further comprise mechanical elements such as input wafer conveyor **412** for supplying wafers **90** and mounting them on wafer holders **415** of respective stage **410** and output wafer conveyor **419** for receiving printed wafers **90** from wafer holders **415** of respective stage **410.** A non-limiting example for wafer handling unit **400** and a schematic description of its operation is illustrated with more details in **Figures 6A-6C****.**

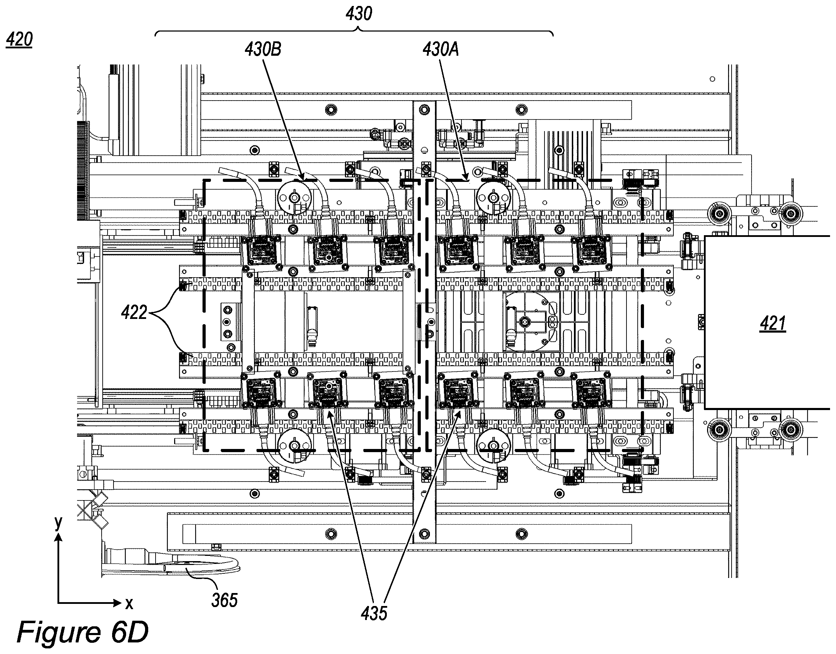

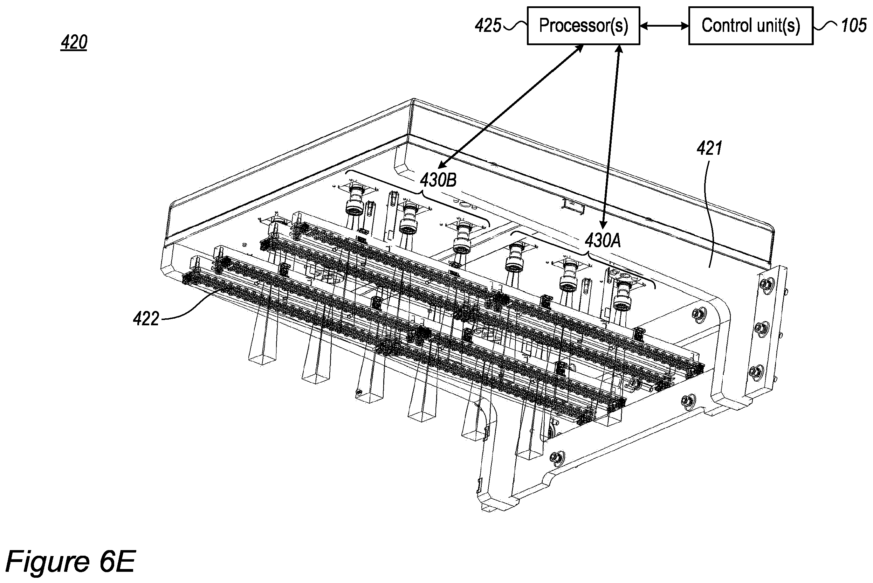

Wafer alignment unit(s) **420** (e.g., **420A** and **420B,** see **Figure 2B**) may be configured to detect and measure features on wafers and to adjust the wafer position to the pattern transfer accordingly - is illustrated with more details in a non-limiting example in **Figures 6D** and **6E****.**

In certain embodiments, wafer handling unit **400** may comprise more than two stages **410,** accompanied with multiplication of any of wafer alignment unit **420,** paste transfer unit **350** and/or print quality control unit **450** - to further increase the throughput of PTP system **100.**

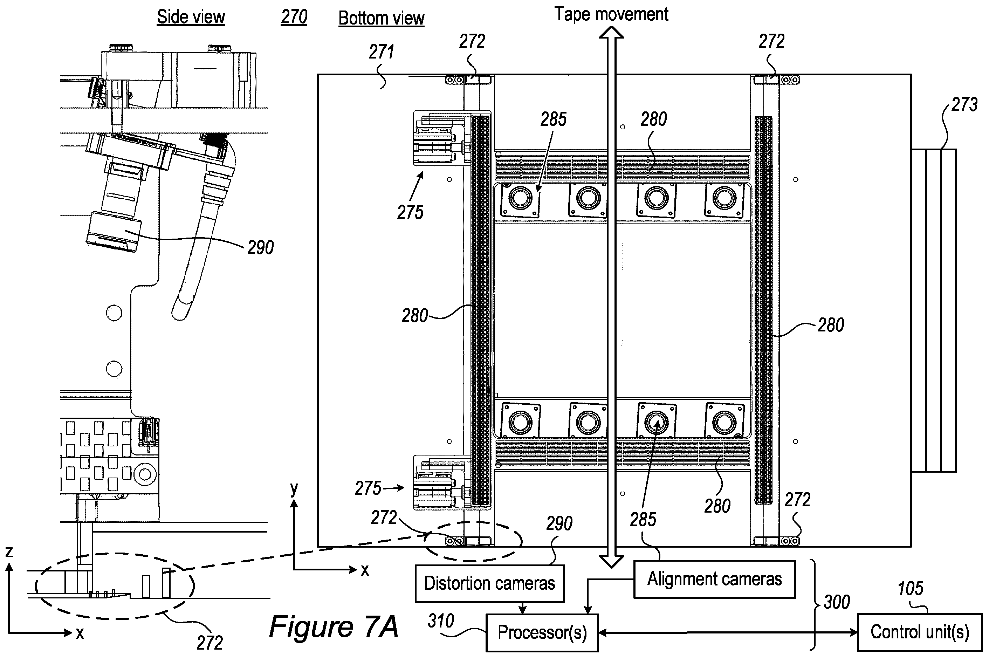

PTP system **100** may further comprise a tape stretching unit **270** (see, e.g., **Figures 2A** and **7A**) configured to affix and flatten respective pattern transfer sheet **205B** during the paste pattern transfer from pattern transfer sheet **205B** to wafer **90B.** PTP system **100** further comprises a trench alignment monitoring unit **300** configured to monitor a position (e.g., in x, y and theta (tilt) directions) and a distortion of the trenches prior to the pattern transfer. A non-limiting example for tape stretching unit **270** and trench alignment monitoring unit **300** is illustrated with more details in **Figures 7A-7C****.**

Paste transfer unit **350** (e.g., a laser scanner) may comprise a laser scanner (scanning head) **355** (e.g., movable along CMD, e.g., by a linear stage, a ball-screw stage, etc.) configured to control the illumination of pattern transfer sheets **205B** by the laser beam for depositing the paste from the patterned trenches of pattern transfer sheets **205B.**

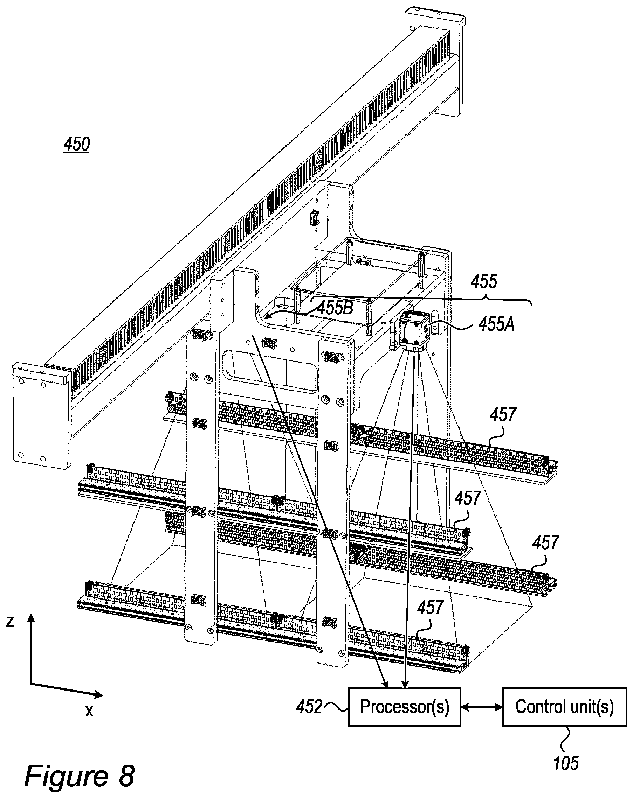

PTP system **100** may further comprise a print quality control unit(s) **450** (e.g., **450A** and **450B,** see **Figure 2B**) configured to control a print quality of the pattern transfer, in particular to detect tiny defects such as openings or gaps within the printed fingers or other defects in the pattern that was transferred onto the wafer. For example, print quality control unit(s) **450** may be based on imaging cameras, which transfer the acquired images of inspected wafers to processor(s) **452** for image processing. A non-limiting example for a print quality control unit **450** is illustrated with more details in **Figure 8****.**

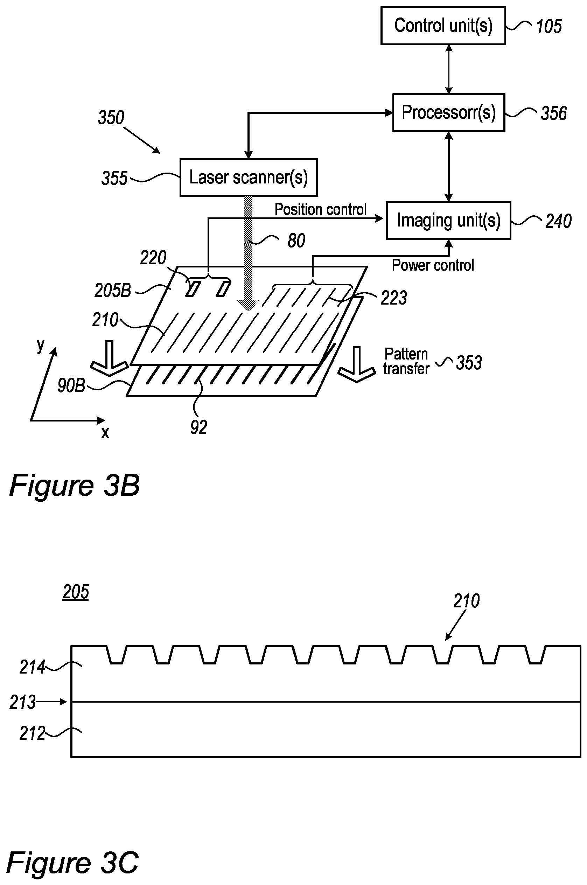

**Figure 3A** is a high-level schematic side view illustration of tape handling unit **200,** according to some embodiments of the invention. Tape handling unit **200** may be configured to move tape **205,** while delivering pattern transfer sheets **205A** one-by-one for the paste filling (at paste filling unit **120,** see, e.g., **Figure 2A**) and/or for the pattern transfer (at pattern transfer unit **350**) by continuously controlling the tape tensions and accurate position of the sheets in both MD and CMD coordinates. **Figures 3B-3E** are high-level schematic illustrations of tape **205** with pattern transfer sheets **205B** (see, e.g., **Figure 2A**) and of paste pattern transfer unit **350,** according to some embodiments of the invention.

The CMD positions of unwinder roll **222** and re-winding roll **242** may be continuously controlled and if needed corrected by help of one or more control unit(s) **105,** e.g., by controlling driving motor(s) thereof. Top dancer(s) **225** and bottom dancer(s) **245** may be configured to support fast stepwise movements of pattern transfer sheets **205A, 205B** (as segments of tape **205**) to their respective positions for paste filling and pattern transfer. Idle rolls **227** (only some of which indicated) may be configured to direct tape movement through tape handling unit **200.**

Tape handling unit **200** may be configured to enable fast and accurate provision and changing of the tape segments (pattern transfer sheets) used to print the wafers. Tape handling unit **200** may be further configured to have a compact design with a minimal footprint, and be set within a stable and rigid frame or chassis for supporting its operation and also for enabling easy maintenance. Tape re-use unit **250** may be set within the frame and in the path of tape **205** and enable reusing tape **205** - making the overall process more efficient and economical.

**Figures 3B-3E** are high-level schematic illustrations of tape **205** with pattern transfer sheets **205B** and of pattern transfer unit **350,** according to some embodiments of the invention, which are disclosed in more details in Chinese Patent Applications Nos. 202111034191X and 2021221306455.

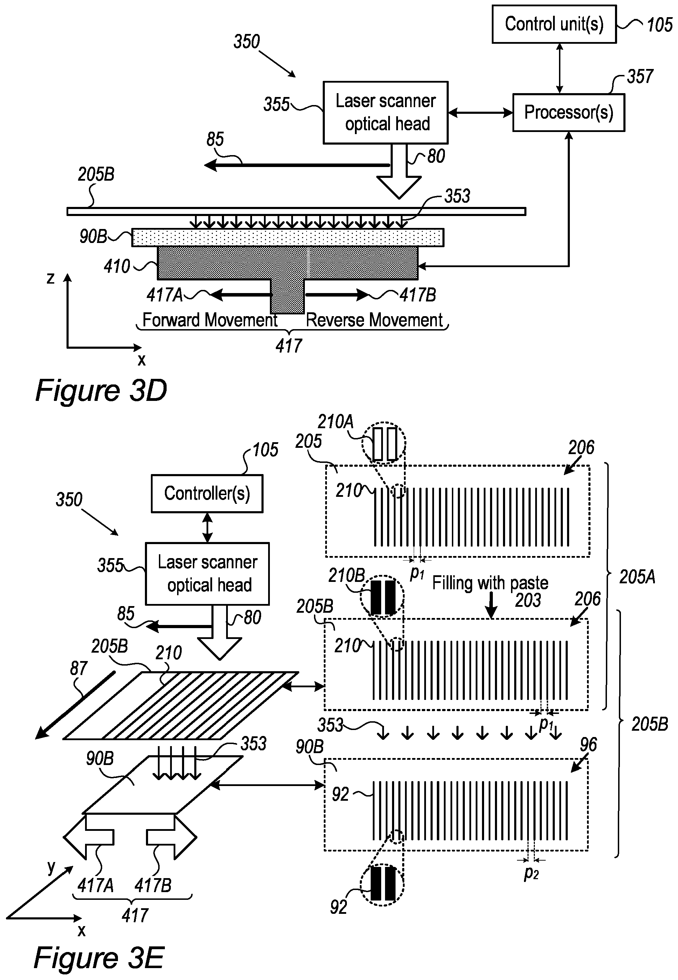

Highly schematic **Figure 3B** illustrates transfer of patterned paste from the pattern transfer sheet **205B** to substrate (e.g., wafer) **90B** using laser illumination by laser scanner(s) **355.** Pattern transfer sheets **205B** comprises a plurality of trenches **210** arranged in a specified pattern and configured to receive printing paste and release the printing paste from trenches **210** upon illumination by laser beam **80** onto a receiving substrate such as wafer **90B.** **Figures 3B** and **3E** schematically illustrate the filling of trenches **110** on an empty pattern transfer sheet on tape **205** with paste to yield filled pattern transfer sheet **205A,** which is then moved further in PTP system **100** to have the paste released from trenches **210** of pattern transfer sheet **205B** onto wafer **90B.** It is noted that while the tape is denoted generally by the numeral **205,** sections of tape **205** that are designed as used as pattern transfer sheets are denoted by numeral **205A** when they are in paste filling stage **203** and are denoted by numeral **205B** when they are in paste pattern transfer stage **353** (illustrated schematically in **Figure 3B** by an arrow).

Pattern transfer sheets may further comprise at least one trace mark **220** that is located outside the specified pattern of trenches **210** and is configured to receive the printing paste. Trace mark(s) **220** is aligned with respect to respective trench(es) **210** and is wider than a width of laser beam **80.** Upon illumination by laser beam **80,** only a part of the paste in trace mark(s) **220** is released (off pattern transfer sheet **205B**), because the width of trace mark(s) **220** is larger than the width of laser beam **80** - yielding a gap that may be used to detect the actual position of the laser beam relative to the position of the corresponding trench.

Pattern transfer sheet may further comprise a plurality of working window marks **223** that are located outside the specified pattern of trenches **210** and are configured to receive the printing paste. Working window marks **223** are set at specified offsets with respect to specified trenches **210** of the specified pattern, with different working window marks **223** being set at different offsets. Working window marks **223** may be used to monitor the power of laser beam **80** needed for releasing paste from all the trenches.

In certain embodiments, pattern transfer sheet may comprise both trace mark(s) **220** and working window marks **223,** which may be configured to enable unambiguous detection by image processing, namely by the trench alignment monitoring unit **300.**

Pattern transfer sheet may further comprise a plurality of alignment marks (not shown) that are located outside the specified pattern of trenches **210,** aligned with respective trenches **210,** configured to receive the printing paste and used to provide initial laser scanner alignment with respect to the specified pattern of trenches **210.**

A trench alignment monitoring unit **300** may be configured to monitor the pattern transfer process optically, e.g., monitoring the transfer of the printing paste by emptying of trenches **210** and of marks **220, 223** onto the substrate, as explained herein. One or more processor(s) **356** or controller(s), in communication with control unit(s) **105,** may be in communication with laser scanner(s) **355** (in paste transfer unit **350**) and imaging unit(s) **300** and be configured to adjust optical parameters of laser illumination by modifying the settings of power and position of laser scanner(s) **355** according to image analysis of images taken by imaging unit(s) **300.** These adjustments and modifications improve the quality and accuracy of pattern transfer stage **353.** For example, processor(s) **356** or controller(s) may be configured to calculate an alignment of laser beam **80** according to traces on pattern transfer sheet (after the paste is released therefrom), e.g., detect misalignment of laser scanner **355** upon detection of asymmetric trace(s) as disclosed in Chinese patent application Nos. 202111034191X and 2021221306455. Processor(s) **356** or controller(s) may be further configured to calculate an effective working window of laser illumination **80** using remaining working window marks **223** on pattern transfer sheet (after the paste is released therefrom), and adjust laser power of the laser scanner **355** accordingly. Additional non-limiting details for PTP systems **100** are provided, e.g., in U.S. Patent No. 9,616,524.

Disclosed PTP systems **100** and tape **205** may be used to print fine lines **92** of thick metallic paste to produce electronic circuits, e.g., creating conductive lines or pads or other features on laminates for PCBs or other printed electronic boards, or on silicon wafers, e.g., for photovoltaic (PV) cells. Other applications may comprise creating conductive features in the manufacturing processes of mobile phones antennas, decorative and functional automotive glasses, semiconductor integrated circuits (IC), semiconductor IC packaging connections, printed circuit boards (PCB), PCB components assembly, optical biological, chemical and environment sensors and detectors, radio frequency identification (RFID) antennas, organic light-emitting diode (OLED) displays (passive or active matrix), OLED illuminations sheets, printed batteries and other applications. For example, in non-limiting solar applications, the metallic paste may comprise metal powder(s), optional glass frits and modifier(s), volatile solvent(s) and non-volatile polymer(s) and/or or resin(s). A non-limiting example for the paste includes SOL9651B^{™} from Heraeus^{™}.

**Figure 3C** is a high-level schematic cross section illustration of tape (pattern transfer sheet) **205,** according to some embodiments of the invention. In certain embodiments, tape **205** may be transparent to laser illumination and comprise at least a top polymer layer **214** comprising trenches **210** and marks **220, 223** (illustrated schematically in **Figure 3B**) which formed by press molding , pneumatic molding or laser molding thereon. In the illustrated non-limiting example, trenches **210** are illustrated as being trapezoid in cross section.

Tape **205** may comprise at least one polymer layer, which may be selected from at least one of: polyethylene, polypropylene, polyethylene terephthalate, polybutylene terephthalate, polyethylene naphthalate, fully aromatic polyester, other copolymer polyester, polymethyl methacrylate, other copolymer acrylate, polycarbonate, polyamide, polysulfone, polyether sulfone, polyether ketone, polyamideimide, polyether imide, aromatic polyimide, alicyclic polyimide, fluorinated polyimide, cellulose acetate, cellulose nitrate, aromatic polyamide, polyvinyl chloride, polyphenol, polyarylate, polyphenylene sulfide, polyphenylene oxide, or polystyrene.

It is noted that while schematic **Figure 3C** shows periodical trenches **210,** marks **220** and/or **223** (illustrated schematically in **Figure 3B**) may comprise trenches, recesses and/or indentations that are embossed in a similar manner into top polymer layer **214,** and may have similar or different profiles. For example, trenches **210,** trace marks **220** and/or working window marks **223,** and alignment marks may have various profiles (cross section shapes), such as trapezoid, rounded, square, rectangular and triangular profiles. In various embodiments, the pattern of trenches **210** on tape **205** may comprise continuous trenches **210** and/or arrays of separated dents. It is noted that the term "trenches" is not to be construed as limiting the shape of trenches **210** to linear elements, but is understood in a broad sense to include any shape of trenches **210.**

Tape **205** may comprise a top polymer layer **214** and a bottom polymer layer **212,** the bottom polymer layer **212** having a melting temperature that is higher than an embossing temperature of the top polymer layer **214.** In some embodiments, top polymer layer **214** may be made of semi-crystalline polymer and have a melting temperature, e.g., below 150°C, below 130°C, below 110°C or have intermediate values. In some embodiments, top polymer layer **214** may be made of amorphous polymer and have a glass temperature below 160°C, e.g., below 140°C, below 120°C, below 100°C or have intermediate values. Bottom polymer layer **212** may have a higher melting temperature than the melting temperature or the glass temperature of top polymer layer **214.** For example, bottom polymer layer **212** may have a melting temperature above 150°C, above 160°C (e.g., bi-axially-oriented polypropylene), above 170°C, and up to 400°C (e.g., certain polyimides), or have intermediate values.

In certain embodiments, top and bottom polymer layers **214, 212** (respectively) may be between 10µm and 100µm thick, e.g., between 15µm and 80µm thick, between 20µm and 60µm thick, between 25µm and 45µm thick, or have other intermediate values - with bottom polymer layer **212** being preferably at least as thick as top polymer layer **214.** The polymer layers may be attached by an adhesive layer **213** that is thinner than 10µm (e.g., thinner than 8µm, thinner than 6µm, thinner than 4µm, thinner than 2µm or have intermediate values) and is likewise transparent to the laser illumination. For example, in certain embodiments, top polymer layer **214** may be thicker than the depth of trenches **210** by several µm, e.g., by 5µm, by 3-7µm, by 1-9µm, or by up to 10µm. For example, trenches **210** may be 20µm deep, top polymer layer **214** may be 20-30µ m thick and bottom polymer layer **212** may range in thickness between 25µm and 45µm (it is noted that thicker bottom polymer layer provide better mechanical performances). It is noted that the term "trenches" is not to be construed as limiting the shape of trenches **210** to linear elements, but is understood in a broad sense to include any shape of trenches **210.**

The temperature and thickness of top and bottom polymer layers (**214, 212** respectively) may be designed so that top polymer layer **214** has good molding, ductility and certain mechanical strength, while bottom polymer layer **212** has good mechanical strength. Both top and bottom polymer layers (**214, 212** respectively) may be designed to have good bonding properties.

**Figures 3D** and **3E** are high-level schematic illustrations of dynamic PTP system **100,** according to some embodiments of the invention. Dynamic PTP system **100** comprises at least one laser scanner optical head(s) **355** configured to illuminate with laser beam(s) **80** pattern transfer sheet **205B** with trenches **210** arranged in a first pattern **206** and holding printing paste in filled trenches **92,** which is then released onto wafers **90** upon the illumination by laser beam **80** from laser scanner optical head(s) **355** configured to have a fast-scanning axis along machine direction **87** (y axis, MD) and may be moved along cross machine direction **85** (x axis, CMD). The releasing of the paste from the trenches implements pattern transfer stage **353,** which is indicated schematically in **Figures 3D** and **3E** by arrows.

Dynamic PTP system **100** may comprises moveable stages **410** with wafer holders **415** affixing wafers **90** (e.g., by help of vacuum clamping) to moveable stage **410** during the releasing of printing paste **92** from pattern transfer sheet **205B.** Moveable stage **410** may comprise any type of stage or wafer holder that can affix and move wafers **90.** Moveable stage **410** may be moved by any type of actuator, e.g., by linear or step motors.

Dynamic PTP system **100** may further comprises controller(s) and/or processor(s) **357,** possibly associated with control unit(s) **105,** and configured to control laser scanner optical head **355** to direct laser beam **80** along trenches **210** (along machine direction **87** - MD), and at a cross machine direction **85** (CMD, scanning direction) across trenches **210.** Processor(s) **357** may further be configured to move moveable stage **410** (the movements are denoted schematically by numeral **417**) to yield a second pattern **96** of deposited paste on wafer **90,** which is different from first pattern **206** of trenches **210** on pattern transfer sheet **205B.** Advantageously, in contrast to current practice which is limited to transferring the same pattern (e.g., of lines) from pattern transfer sheet **205B** to wafer **90,** various embodiments of dynamic PTP system **100** enable to deposit the transferred metal paste onto wafer **90** at patterns (second pattern 96) which are different from first pattern **206** of trenches **210** on pattern transfer sheet **205B.**

As illustrated schematically in **Figure 3E****,** wafer **90B** may comprise a pattern of substantially parallel linear locations arranged with a certain receiving pitch p₂, for receiving the paste release from trenches **210** of pattern transfer sheet **205B,** in a close proximity (e.g., in a range of between 0.1mm and 0.5mm) to pattern transfer sheet **205B** in such a way that the first trench on pattern transfer sheet **205B** is located exactly opposite to the first linear location on wafer **90B.** Scanning the paste-filled trench pattern **206** on pattern transfer sheet **205B** by laser beam **80** sequentially from the first trench to the last trench results in the deposition of the paste onto the specified locations on wafer **90B** to yield deposited paste in a specified pattern **96.** As processor(s) **357** and/or control unit **105** move wafer **90B** during the scanning (movements indicated schematically by numeral **417**), the paste is deposited at a different pitch (p₂≠p₁), depending on the direction and speed of motion.

It is noted that scanning along x-axis may be carried out in forward and/or backward directions, and respective movements **417** of wafer **90** may be adjusted accordingly. In the present disclosure cross machine direction **85** is illustrated in one direction, as a non-limiting example.

For example, first pattern **206** of trenches **210** on pattern transfer sheet **205B** may have a first pitch ("p₁") and second pattern **96** of deposited paste on wafer **90** may have a second pitch ("p₂"), that may be smaller or larger than first pitch ("p₁"), e.g., p₁>p₂ or p₁<p₂. It is noted that second pattern **96** may differ from first pattern **206** over the whole extent of wafer **90** or over a part of the extent of wafer **90.** In some examples, the difference of pattern may comprise p₁>p₂ in some area(s) of wafer **90** while p₁<p₂ in other area(s) of wafer **90.**

In certain embodiments, with first pitch p₁ being larger than second pitch p₂ (p₁>p₂), processor **357** may be configured to move moveable stage **410** along scanning direction **85** (CMD, denoted **417A**) at a forward speed set to convert first pitch p₁ to second pitch p₂. For example, with forward speed denoted as v_{F} and the time between deposition of consecutive lines denoted as t, p₂=p₁-v_{F}·t. Alternatively or complementarily, denoting the scanner speed across trenches **210** as v_{S}=p₁/t, the approximate relation between the pitches is p₂=p₁·(v_{S}-v_{F})/v_{S}.

In certain embodiments, with first pitch p₁ being smaller than second pitch p₂ (p₁<p₂), processor **357** may be configured to move moveable stage **410** against (in a contrary direction to) scanning direction **85** (CMD, denoted **417B**) at a backward speed set to convert first pitch p₁ to second pitch p₂. For example, with backward speed denoted as v_{B} and the time between deposition of consecutive lines denoted as t, p₂=p₁+v_{B}·t. Alternatively or complementarily, denoting the scanner speed across trenches **210** as vs=p₁/t, the approximate relation between the pitches is p₂=p₁-(v_{S}+v_{B})/v_{S}.

**Figure 4** is a high-level schematic illustration of tape re-use unit **250,** according to some embodiments of the invention. Tape cleaning unit **252** of tape re-use unit **250** may comprise a pre-cleaning compartment **252A** and a cleaning compartment **252B** configured to remove paste remains having different characteristics (e.g., pre-cleaning may remove rougher clumps of paste while cleaning may remove finer paste remains), and possibly may be preceded by a scraper device for removing paste smears. Tape cleaning may be carried out physically, e.g., by turbulent liquid flow, agitation, application of ultrasound, etc., and/or chemically, e.g., applying corresponding solvents. Fluid introduction to and removal from pre-cleaning compartment **252A** and/or cleaning compartment **252B** may be managed by a recirculation unit **254** (shown schematically), comprising, e.g., pump(s) and filter(s) for reusing respective cleaning solution(s). Tape drying unit **255** may follow tape cleaning unit **252** and be configured to dry tape **205** and prepare it for future use, prior to rolling tape **205** onto re-winding roll **242.** Idle rolls **244, 246** and optionally additional rolls may be set to direct tape movement through and after tape re-use unit **250.** During the tape segment advance movement, one or more idles rolls **248** shown in the bottom part of unit **250** may move upward enabling smooth tape movement and continuous tension control performing as dancers, similar to dancers **225, 245.** After finishing the segment advance, rolls **248** may go downwards under their own weight. Alternatively or complementarily, tape re-use unit **250** may comprise one or more dancers configured to maintain the tension in tape **205** moving through tape re-use unit **250.**

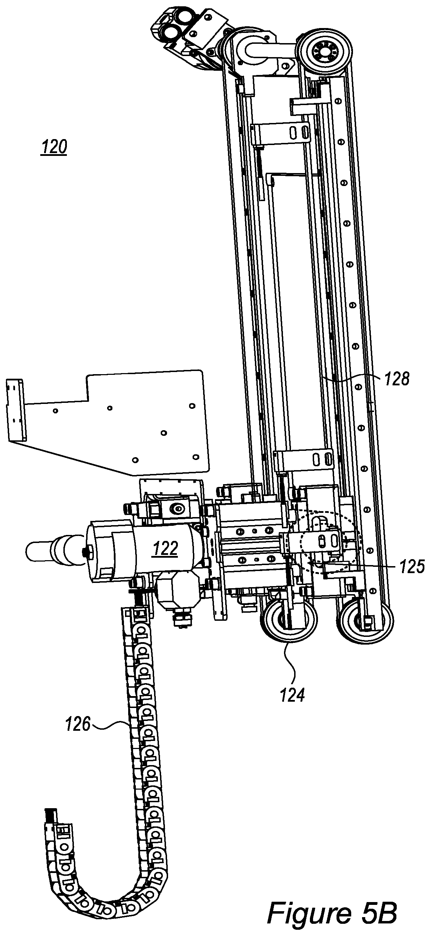

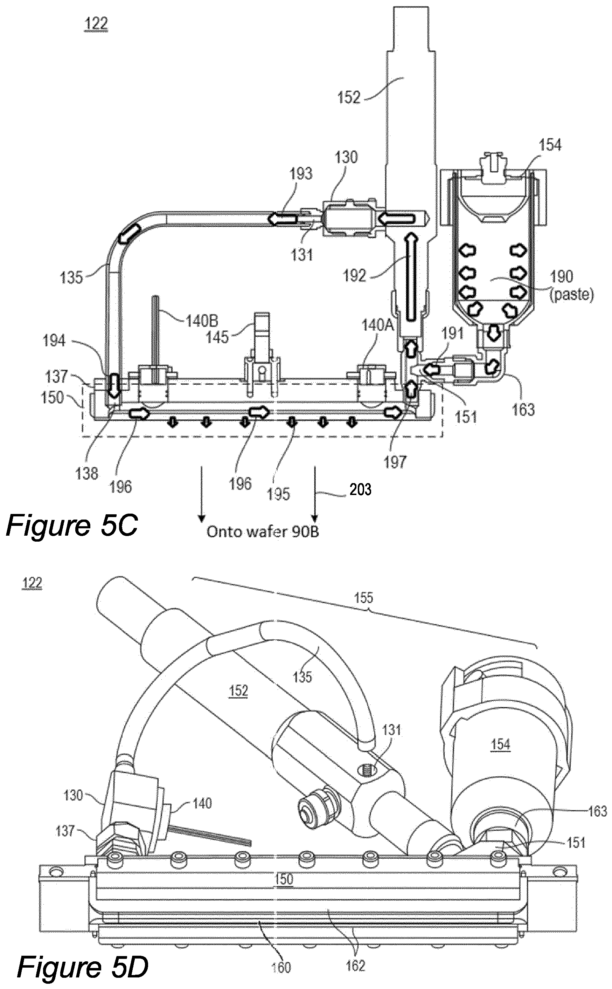

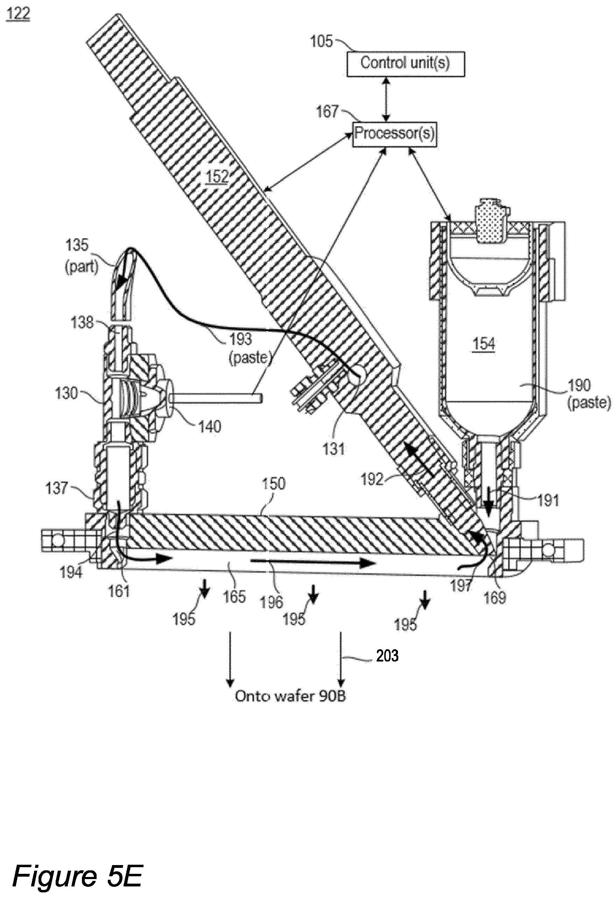

**Figures 5A** and **5B** are high-level schematic illustrations of paste filling unit **120,** according to some embodiments of the invention. **Figure 5A** is a perspective view and **Figure 5B** is a side view. **Figures 5C-5E** are high-level schematic illustrations of filling head **122,** according to some embodiments of the invention. **Figures 5C** and **5E** are schematic side view in cross section and **Figure 5D** is a perspective view from below filling head **122.**

As illustrated schematically in **Figures 5A** and **5B****,** paste filling unit **120** may comprise a frame on which paste filling head **122** and bottom roll **125** are mounted, and with respect to which they are moved simultaneously. Movements of the paste filling head assembly may be controlled by one or more control unit(s) **105** e.g., via controlling respective flexible rack **126** attached to paste filling head **122,** drive motors **124** and/or gantry motion system **128.**

Bottom roll **125** may be configured to counter paste filling head **122** and support pattern transfer sheet **205A** of tape **205** during the filling of pattern transfer sheet **205A** with the paste by paste filling head **122.** Bottom roll **125** may be configured to roll during operation, possibly controllably.

Paste filling unit **120** may be configured to enable fast, uniform and accurate filling of the high viscosity paste into the trenches having a high aspect ratio. Paste filling unit **120** may be further configured to clean the surface of tape **205** after filling, e.g., disclosed in WIPO Publication No. 2015128857.

As illustrated schematically in **Figures 5C-5E****,** and disclosed in more details in Chinese Patent Applications Nos. 2021106730065 and 2021213505781, filling head **122** of paste filling unit **120** may comprise at least two feeding openings **161, 169,** an internal cavity **165** and at least one dispensing opening **160** that are in fluid communication (see, e.g., **Figures 5D** and **5E**) and a pressurized paste supply unit **155** configured to circulate paste **190** through printing head **150.** The pressure in the pressurized paste supply unit may be adjusted to maintain continuous circulation of the paste through feeding openings **161, 169** and internal cavity **165** and to control dispensing of the paste through dispensing opening(s) **160.** For example, pressurized paste supply unit **155** may comprise a pressurized paste reservoir **154** and a paste pump **152** in fluid communication with internal cavity **165** of printing head **150,** which are configurated to circulate the paste therethrough. In non-limiting examples, paste pump **152** may comprise rotating pressure-tight displacement systems with self-sealing, rotor/stator designs for dispensing precise volumes such as eco-PEN450^{™} from Dymax^{™}.

In various embodiments, paste filling unit **120** comprises at least one pressure sensor **140** configured to measure the pressure of the circulating paste, e.g., pressure sensor **140** illustrated schematically in **Figures 5C-5E** and associated with a paste mixer **130** or pressure sensors **140A, 140B** illustrated schematically in **Figure 5C****,** at either ends of printing head **150,** as non-limiting examples. Alternatively or complementarily, pressure measurement may be implemented within elements of pressurized paste supply unit **155,** such as paste pump **152** and/or paste reservoir **154.** Paste filling unit **120** may further comprise at least one processor **167** and/or controller (shown schematically in **Figure 5E**), in communication with control unit(s) **105** and configured to adjust the pressure in pressurized paste supply unit **155** (or its components) with respect to the measured pressure of the circulating paste. Paste filling unit **120** may further comprise one or more paste mixer(s) **130** configured to mix the circulating paste. For example, paste mixer(s) **130** may be a static mixer, mixing the paste by utilizing its pressurization. In non-limiting examples, paste mixer(s) **130** may comprise plastic disposable static mixers such as GXF-10-2-ME^{™} from Stamixco^{™} made of large diameter plastic housing that includes multiple mixing elements.

Pressurized paste supply unit **155** may be further configured to introduce the paste into internal cavity **165** via at least one entry opening **161** of the at least two feeding openings and to receive the circulated paste via at least one exit opening **169** of the feeding openings in printing head **150.** Typically, entry opening(s) **161** and exit opening(s) **169** are at the top of printing head **150,** opposite to dispensing opening(s) **160** which faces the pattern transfer sheet with trenches which are to be filled by the paste. Alternatively or complementarily, entry opening(s) **161** and/or exit opening(s) **169** may be positioned on sides and/or extension(s) of printing head **150.**

Pressurized paste supply unit **155** may comprise pressure-controlled paste reservoir **154,** paste pump **152** and mixer **130** that are in fluid communication. Pressure-controlled paste reservoir **154** may be configured to deliver paste to paste pump **152,** which may be configured to deliver the paste through mixer **130** to entry opening(s) **161.** Pressurized paste supply unit **155** may be further configured to mix paste from exit opening(s) **169** with the paste delivered from pressure-controlled paste reservoir **154** to paste pump **152.** For example, as illustrated schematically in **Figures 5C** and **5E****,** paste **190** in paste reservoir **154** may be delivered **(191)** to paste pump **152,** mixing **(192)** with paste **197** exiting from exit opening(s) **169** of printing head **150,** to be pumped by paste pump **152** into mixer **130.** Paste **193** from mixer **130** may be delivered **(194)** to entry opening(s) **161** of printing head **150,** wherein paste **196** moves along internal cavity **165** and some paste **195** may be dispensed through dispensing opening(s) **160** to form patterns on the transfer sheet **205A** such as lines to be then printed (after the tape movement, from transfer sheet **205B)** on the receiving substrate such as wafer **90** (e.g., silver lines of about 20µm width on silicon wafers for PV cells, see, for non-limiting examples, Lossen et al. 2015). Remaining paste **197** is then mixed with paste **191** from paste reservoir **154** (e.g., delivered through nozzle **163** at junction **151)** to compensate for the dispensed amount, and the paste is circulated through Paste filling unit **120** to maintain its mechanical characteristics and support continued mixing of the paste to maintain its uniform composition. In certain embodiments, paste filling unit **120** may be further configured to modify paste composition, e.g., by adding additives such as solvents to keep the paste homogenized, possibly in relation to the monitored pressures throughout paste filling unit **120.** For example, additives such as solvents may be added to the paste entering mixer **130** if needed.

In various embodiments, printing head **150,** internal cavity **165** and dispensing slit as opening **160** limited by slit edges **162** (e.g., metallic slit lips) may be elongated (see, e.g., **Figure 5D**) and configured with respect to paste properties (e.g., viscosity values), specified throughput and specified features (e.g., length, width and optionally cross section) of the lines or other elements that are to be dispensed by printing head **150.** In certain embodiments, dispensing opening **160** may comprise one or more slits, one or more opening, a plurality of linearly-arranged openings, e.g., one or more lines of circular or elliptical openings, and so forth.

In various embodiments, paste material may comprise conductive silver based metallic paste, and may typically be of high viscosity (e.g., in the range of several tens to several hundreds of Pa·s). For example, in non-limiting solar applications, the metallic paste may comprise metal powder(s), optional glass frits and modifier(s), volatile solvent(s) and non-volatile polymer(s) and/or or resin(s). A non-limiting example for the paste includes SOL9651B^{™} from Heraeus^{™}.

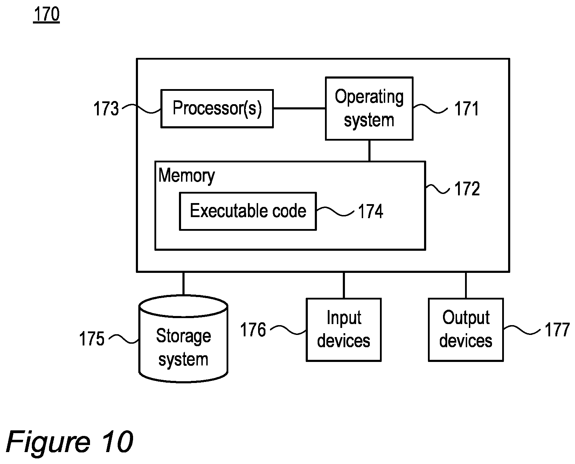

Paste filling unit **120** may comprise one or more pressure sensor (s) **140, 140A, 140B** configured to measure the pressure of the circulating paste at one or more respective locations along the paste circulation path. For example, pressure sensor(s) **140, 140A, 140B** may be set adjacent to entry opening(s) **161,** exit opening(s) **169,** in fluid communication with internal cavity **165** of printing head **150** and/or in association with any of mixer **130,** paste reservoir **154** and/or paste pump **152.** Pressure-related indications from pressurized paste reservoir **154** and/or paste pump **152** may also be used to monitor paste circulation through Paste filling unit **120** and/or to monitor and possibly modify the paste properties such as its viscosity, e.g., by adding solvent. Paste filling unit **120** may further comprise at least one controller (e.g., as part of or in communication with control unit **105** and/or as at least one computer processor **173** as illustrated in **Figure 10**), in communication with any of the components of paste filling unit **120,** e.g., via communication link(s)) configured to adjust the pressure in pressure-controlled paste reservoir **154** and/or paste pump **152** with respect to the measured pressure of the circulating paste, e.g., as received from one or more pressure sensor (s) **140, 140A, 140B.** In non-limiting examples, any of pressure sensor(s) **140** may comprise, e.g., small profile, media compatible, piezoresistive silicon pressure sensors packaged in a stainless-steel housing (e.g., MEAS 86A^{™} from T.E. connectivity^{™} or equivalent sensors).

In various embodiments, pressure-controlled paste reservoir **154** and paste pump **152** may open adjacently to exit opening(s) **169** of printing head **150** and paste filling unit **120** may comprise a conduit **135** connecting the exit of mixer **130** to entry opening(s) **161** of printing head **150.** In some embodiments, pressure-controlled paste reservoir **154** and paste pump **152** may open adjacently to exit opening(s) **169** of printing head **150,** mixer **130** may be adjacent to entry opening(s) **161** of printing head **150,** and conduit **135** may connect paste pump **152** to mixer **130.** Pressure sensor **140** may be associated with mixer **130.** The dimensions and orientations of paste reservoir **154** and paste pump **152** may vary, e.g., both paste reservoir **154** and paste pump **152** may be set perpendicularly to printing head **150** (see, e.g., **Figure 5C**), or one or both of paste reservoir **154** and paste pump **154** may be set at an angle to printing head **150.** For example, paste pump **152** may be set obliquely to spread its weight more evenly over printing head **150,** as illustrated schematically in **Figures 5D** and **5E****.**

In various embodiments, conduit **135** may be adjusted to conform to any arrangement of paste reservoir **154,** paste pump **152** and mixer **130,** so as to make paste filling unit **120** more compact or adjust it to a given space and weight distribution requirements within the printing machine. Holder **145** (see, e.g., **Figure** 5C) is illustrated schematically as an attachment element for attaching paste filling unit **120** to the printing machine (see, e.g., U.S. Patent No. 9,616,524 for a non-limiting example). In non-limiting examples, conduit **135** may be connected between an opening **131** in mixer **130** and an opening **138** of connector **137** at entry opening **161** in printing head **150** (see, e.g., **Figure 5C**) or between opening **131** in paste pump **152** and opening **138** in mixer **130** (see, e.g., **Figure 5E**) .

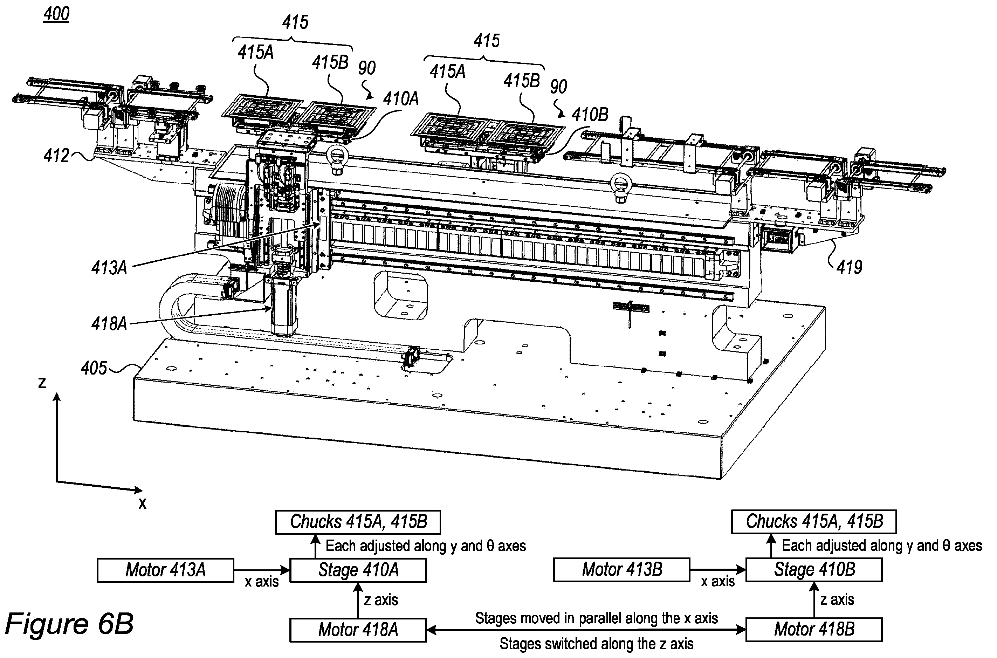

**Figures 6A-6C** are high-level schematic illustrations of wafer handling unit **400** and of its operation, according to some embodiments of the invention. **Figure 6A** is a side view, **Figure 6B** is a partial perspective view and **Figure 6C** is a schematic illustration of the wafer handling.

Wafer handling unit **400** is configured to increase the throughput of PTP system **100** by enabling parallel processing of different wafers **90.** Wafer holders **415A, 415B** (see **Figure 6B****,** e.g., vacuum chucks) may be configured to move in parallel (e.g., along the horizontal x axis and also along vertical z axis) and apply wafer position corrections during movements along the horizontal y axis and with respect the wafer's tilting angle (denoted θ). For example, each stage **410A, 410B** may be configured to adjust both wafer holders **415A, 415B** (that may adjust the wafer positions) along the x-axis and the z axis. Correspondingly, wafer handling unit **400** may comprise one or more motors **413,** e.g., a linear motor **413A** (illustrated schematically) for moving stage **410A,** along the x axis and a motor **418A** (illustrated schematically) for adjusting the position of wafer stage **410A** (with holders **415A** and **415B**) along the z axis. The positions along the y and θ axes are adjusted by each holder **415** separately. Accordingly, a linear motor **413B** (not shown), which is mounted in parallel to motor **413A,** moves stage **410B** along x axis and motor **418B** adjusts wafer stage **410B** (holders **415A** and **415B)** along the z axis. Both stages **410A** and **410B** are operated in parallel along the x axis by motors **413A** and **413B** and are separated when moving in opposite directions by changing their z-position by motors **418A** and **418B,** accordingly.

In various embodiments, wafer handling unit **400** may be configured to have two stages working in parallel which are each movable along x and z directions. Each stage **410** may comprise two holders **415** for holding wafers **90,** with each holder **415** ensuring wafer movement along the y and θ axes (θ denoting tilting of the wafer) thus enabling faster wafer handling and continuous wafers movements during the pattern transfer process. Multiple cameras may be configured to capture images of the incoming wafers to enable more accurate wafer alignment within the printing system thus more accurate alignment of printed conductive lines onto wafer pattern(s).

As illustrated schematically in **Figure 6C****,** wafer handling unit **400** may be configured to move wafers **90** from input conveyor **412** through pre-alignment measurement stage (receiving the wafer at position **90A**), pattern transfer printing stage (receiving the wafer at position **90B**) and print quality control stage (receiving the wafer at position **90C**) to output conveyor **419,** while parallelizing wafer treatment so that wafers supported by either stage **410A, 410B** are processed in parallel. (e.g., during pattern transfer **90B** to Wafer 1 (held by holder **415A**) of Stage 1 **(410A),** Wafer 2 (held by holder **415B**) of Stage 2 **(410B)** may already be pre-aligned (wafer **90A**), while Wafers 1 and 2 (held by holders **415A, 415B,** respectively) of Stage 1 **(410A)** are pre-aligned **(90A)** and printed **(90B),** respectively, Wafer 1 (held by holder **415A**) of Stage 2 **(410B)** undergoes quality control (wafer **90C**), etc. Wafer handling unit **400** may be mounted on a granite base **405** (see, e.g., in **Figure 6B**) to stabilize all the modules and reduce inaccuracies that may result from frequent and fast movements of wafer stages and other moving parts.

Wafers **90** may be a silicon wafer, as used, e.g., for manufacturing PV cells of different types as described in detail, e.g., in Luque and Hegedus (eds.) 2011, Handbook of photovoltaic science and engineering, pages 276-277.

**Figures 6D** and **6E** are high-level schematic illustrations of wafer alignment unit **420,** according to some embodiments of the invention. Each wafer **90A** may be identified by specified features thereof and its placement may be adjusted relative to the paste transfer printing unit according to the exact locations of the specified features. For example, selective emitter (SE) solar cells comprise localized lines (SE lines) of heavy doping in Si substrate onto which the metal contacts are printed by paste transfer. Wafer alignment unit **420** may be configured to measure the locations of the SE lines on wafer **90A** and the position of the wafer may be adjusted so that the paste transfer for each printed finger is done by paste transfer unit **350** with respect to the positions of the SE lines, as determined by wafer alignment unit **420** in order to increase the overall printing accuracy.

Wafer alignment unit **420** may comprise camera array(s) **430** with associated illumination, configured to measure the locations of specific features on wafer **90A,** e.g., of the SE lines. For example, wafer alignment unit **420** may comprise multiple imaging cameras configured to capture at least a part of a perimeter of wafer **90,** possibly most or all of the wafer perimeter. The cameras of array(s) **430** may be configured to image the wafer corners (using e.g., four cameras for the areas near the wafer corners) as well as features at a middle of the wafer (using, e.g., two or more cameras to image areas including two opposite ends of the specific features, such as several trenches located in the middle of the wafer).

In case of two wafer holders **415A, 415B** with respective wafer per stage **410,** camera arrays **430** may comprise two respective sub-arrays **430A, 430B,** each comprising, e.g., two rows of cameras, configured to measure wafer **90A** at the respective position (e.g., as Wafer 1 or Wafer 2, illustrated schematically in **Figure 6C**). In non-limiting examples, each camera sub-array **430A, 430B** may comprise six cameras **435** with respective illumination sources (e.g., four LEDs boards **422** per sub-array configured to provide uniform illumination of the camera's Field of View (FoV) with high contrast of the SE lines images) - which may be configured to provide accurate x and θ coordinates of the SE lines and the SE pitch even if the SE pitch is not unform in the x direction (CMD).

Camera array(s) **430** may be mounted to the system chassis to ensure their stability and accuracy of the measurements. Processors **425** may receive the images from camera arrays **430,** apply high resolution image processing algorithms to yield an accuracy of the SE line measurements of one to few microns, and provide the data to control unit(s) **105** to adjust the wafer position relative to paste transfer unit **350.** Cameras **435** may be, for example, of 5 Mpix CMOS type, with an imaging lens, for example, of 25mm focal length. It should be noted that number of cameras **435** in each array **430** affects the accuracy of wafer alignment to the transfer sheet pattern thus of the position of printed finger lines **92** onto SE lines on wafer **90B** (see, e.g., **Figure 3E**). As a non-limiting example, the number of cameras may be six thus enabling to determine accurate x, θ - positions of the first and the last SE lines by four corner cameras as well as to estimate the SE pitch along the CMD by help of two intermediate cameras. In a non-limiting example, four LED boards **422** may be used to enable uniform illumination of FOVs of all the cameras by near-normal illumination, which enables high contrast imaging of the SE lines.

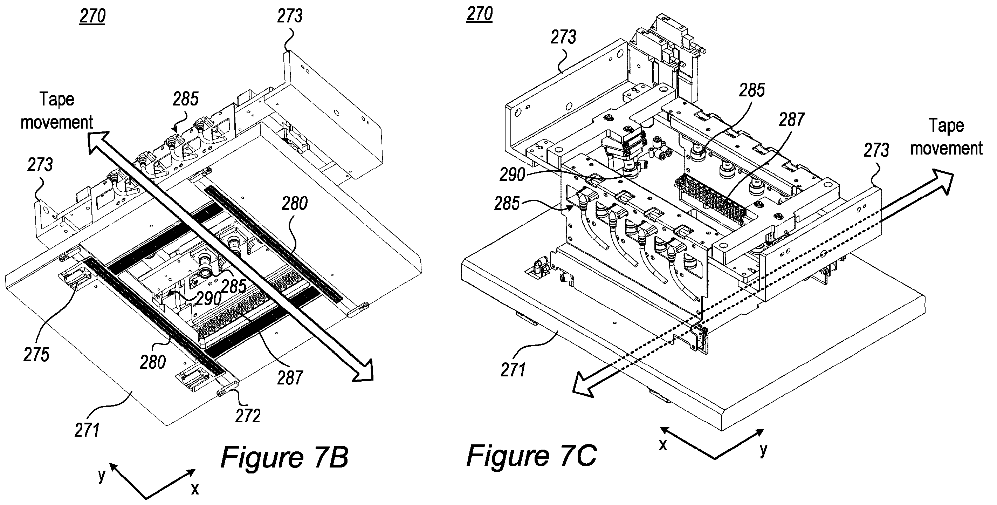

**Figures 7A-7C** are high-level schematic illustrations of tape stretching unit **270** and trench alignment monitoring unit **300,** according to some embodiments of the invention. **Figure 7A** is a front view (without tape **205**) with an inset side view and **Figures 7B** and **7C** are perspective views from below (facing the front of tape stretching unit **270**) and from above (facing the back of tape stretching unit **270** and alignment monitoring unit **300**). Tape stretching unit **270** and trench alignment monitoring unit **300** may be set with respect to plate **271** and secured by supports **273** to the frame of PTP system **100.**

Tape stretching unit **270** may be configured to stretch tape **205** at the pattern transfer stage (e.g., pattern transfer sheet **205B**) to keep pattern transfer sheet (tape segment) **205B** straight and flat, avoiding deformations to the shape of paste-filled trenches thereupon and to prevent direct contact between pattern transfer sheet **205B** and wafer **90B** onto which the paste is transferred (e.g., keeping a gap of, e.g., in the range of 100µm to 500µm between pattern transfer sheet **205B** and wafer **90B**). Moreover, tape stretching unit **270** may be configured to avoid interference to wafer movements by wafer handling unit **400.** For example, **Figures 7A** and **7B** illustrate schematically the use of vacuum bars **280** configured to affix and flatten tape **205** using vacuum application and a stretching mechanism 275 and may comprise recesses **272** for applying vacuum to the transfer sheet by keeping its planarity.

Trench alignment monitoring unit **300** is configured to monitor the trenches' x, θ - positions and distortions, e.g., using multiple imaging cameras configured and/or located to capture ends of the trenches and to capture at least middle-sections of the trenches. For example, trench alignment monitoring unit **300** may be configured to measure the ends of the trenches using cameras **285** (e.g., four pairs of alignment cameras, one camera of each pair at each end of the trenches) as well as tilted cameras **290** (see, e.g., one of tilted cameras **290** illustrated **Figure 7C** and in a larger scale on the left part side view in **Figure 7A**) - set to measure trench distortions at central portions of the trenches. Tilted imaging cameras **290** may be tilted with respect to the vertical z direction so as to capture the middle-sections of the trenches without obstructing the illumination of the trenches (e.g., not positioned above the pattern transfer sheet).

Corresponding image processing algorithms may be applied to the images of cameras **285, 290** in one or more processor(s) **310** associated with control unit(s) **105** - to measure trench positions (e.g., x and θ-position(s)) and distortions, and optimize the positioning accuracy of laser beam **80** with respect to some or every paste-filled trench of pattern transfer sheet **205B** during scanning. The measurements may be used to increase accuracy and/or to reduce the required beam width (wider beams **80** were previously used to compensate for inaccuracies). Trench alignment monitoring unit **300** may further comprise illumination unit(s), e.g., LED boards **287** (see, e.g., **Figures 7B** and **7C**) located below the camera assemblies, configured to provide the required illumination of the trenches for the fields of view of respective cameras **285, 290.** In certain embodiments, imaging cameras **285** and **290** may be assembled of the same CMOS camera and imaging lens as are used in the wafer alignment module.

Paste transfer unit **350** may comprise a high-power laser and optical head **355,** which forms laser beam **80** that releases the paste from the trenches in pattern transfer sheet **205B** onto wafer **90B.**

Optical head **355** may be movable and configured to be moved along CMD (x axis), e.g., with a velocity of about 0.5m/s or more, with optical head **355** configured to focus laser beam **80** to specified spot shape(s) (that are effective in releasing the paste from the trenches of pattern transfer sheet **205B**) and to move this spot in along MD (y axis) with very high velocity, e.g. 500m/s. Optical head **355** may be movable along CMD (x axis), e.g., by a precise linear motor to adjust the exact location of laser beam **80** with respect to the actual locations of the trenches on the pattern transfer sheet **205B.** Optical head **355** may be controllably tiltable (e.g., by the same or by an additional motor) to adjust for tilts of pattern transfer sheet **205B** that may remain with disclosed tape stretching, and as measured by trench alignment monitoring unit **300.** The laser used in pattern transfer unit **350** may be any of one of the following groups: a) CW, QCW, pulse; b) IR, NIR, Visible; c) solid state, fiber, gaseous, laser diode. The scanner for MD axis may be any commercially available linear scanner enabling the scanning velocity of several hundreds of m/sec. The motor assembly for CMD axis movement of optical head 355 may be based on a linear motor or a ball screw motor.

Paste transfer unit 350 may be controllable by control unit(s) 105 with respect to the illumination and the various movement parameters, possibly adjusted and monitored by associated processor(s).

**Figure 8** is a high-level schematic illustration of print quality control (QC) unit 450, according to some embodiments of the invention. Print quality control unit 450 may be configured to detect defects in the pattern transfer using one or more cameras 455 configured to capture high resolution images (e.g., having 20 megapixels or more) of printed wafers 90C, with corresponding illumination 457 (e.g., four dark field LEDs boards along the x direction, CMD, configured to provide uniform illumination of whole wafer 90C). Print quality control unit **450** may be configured to provide high contrast and avoid or reduce optical noise.

Print QC unit **450** may comprise two respective cameras **455A, 455B** (the latter indicated schematically by an arrow, cameras **455B** are opposite to camera **455A** but are not visible on **Figure 8****,** except for the schematic illustration of its FoV). Cameras **455** are configured to measure wafer **90C** at the respective position (e.g., as Wafer 1 or Wafer 2, illustrated schematically in **Figure 6C**). Processors **452** may receive the images from cameras **455,** apply high resolution image processing algorithms to detect tiny printing defects like small cuts or local misprints, and provide the data to control unit(s) **105** to correct parameters of the process. Cameras **455A** and **455B** may be, in a non-limiting example, of 20Mpix CMOS type equipped with an imaging lens enabling FoV of about 230 mm by 230 mm. The LED boards may be installed on two sides and on two height levels in order to ensure uniform illumination of the whole wafer, as is shown schematically in **Figure 8****.**

Elements from **Figures 1-8** may be combined in any operable combination, and the illustration of certain elements in certain figures and not in others merely serves an explanatory purpose and is non-limiting.

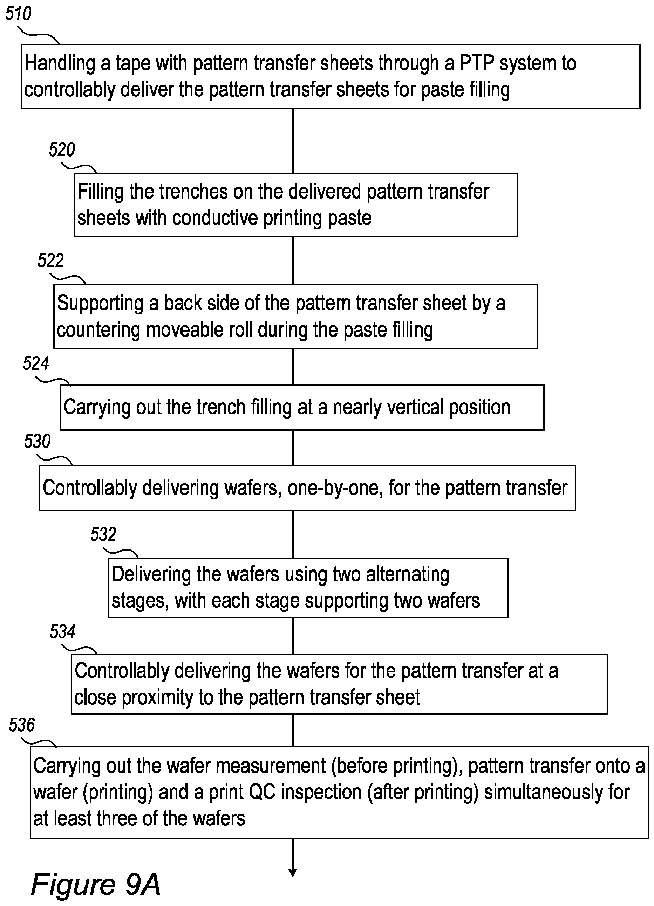

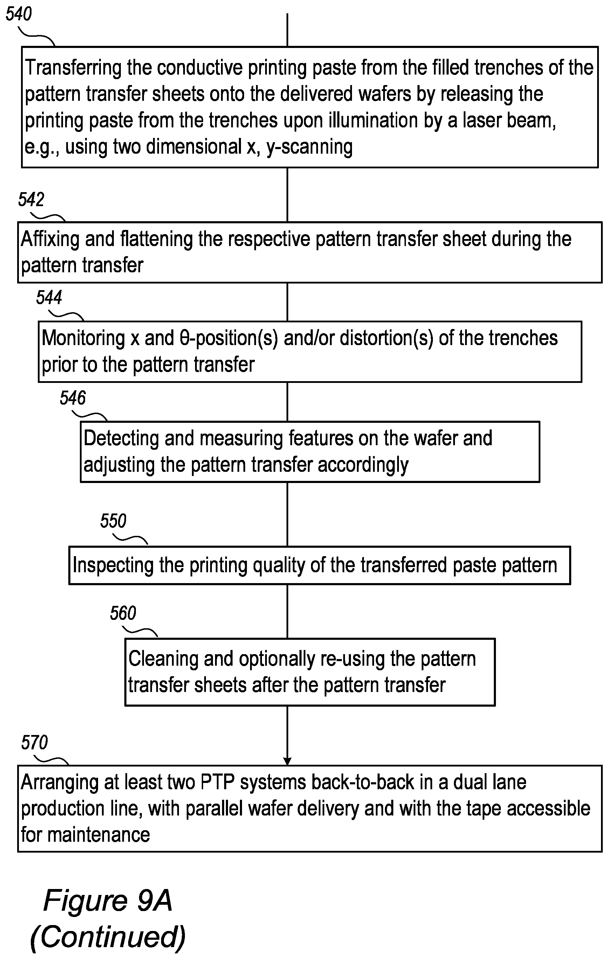

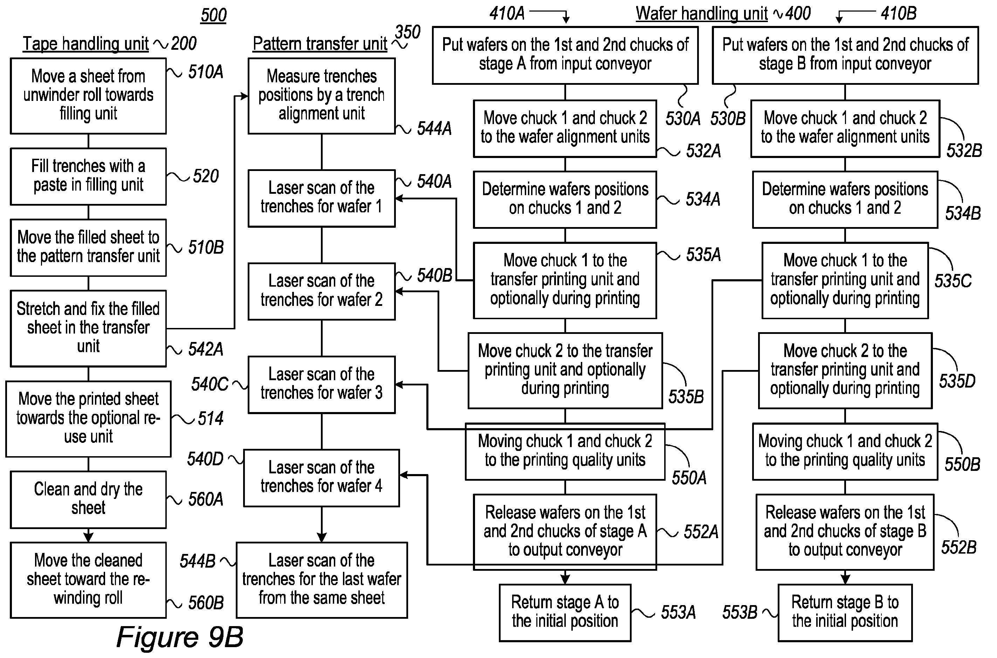

**Figure 9A** is a high-level flowchart illustrating a pattern transfer printing (PTP) method 500, according to some embodiments of the invention. **Figure 9B** is a high-level flowchart illustrating in general the parallel processes in pattern transfer printing (PTP) method **500,** according to some embodiments of the invention. The method stages may be carried out with respect to PTP system **100** described above, which may optionally be configured to implement method **500.** Method **500** may be at least partially implemented by at least one computer processor or by at least one control unit **105** (e.g., one or more personal computers, PCs and/or one or more programmable logic controllers, PLCs) or by their combinations). Certain embodiments comprise computer program products comprising a computer readable storage medium having computer readable program embodied therewith and configured to carry out the relevant stages of PTP method **500.** PTP method **500** may comprise the following stages.

As illustrated in **Figure 9A****,** PTP method **500** comprises handling a tape through a PTP system, the tape comprising, as sections thereof, a plurality of pattern transfer sheets having respective patterns of trenches - to controllably deliver the pattern transfer sheets for paste filling (stage **510**), filling the trenches on the delivered pattern transfer sheets with conductive printing paste (stage **520**), controllably delivering a plurality of wafers (one-by-one) for the pattern transfer (stage **530**), and transferring the conductive printing paste from a plurality of filled trenches on the pattern transfer sheets onto a respective one of the delivered wafers, by releasing the printing paste from the trenches upon illumination by a laser beam, e.g., by help of two dimensional x, y-scanning (stage **540**).

PTP method **500** may further comprise cleaning the pattern transfer sheets after the pattern transfer to provide reusable pattern transfer sheets, and optionally re-using the cleaned pattern transfer sheets (stage **560**).

PTP method **500** may further comprise supporting a back side of the pattern transfer sheet by a countering moveable roll during the paste filling (stage **522**). PTP method **500** may further comprise carrying out the trench filling at a nearly vertical position (stage **524**), e.g., at a nearly vertical angle (in the range of 0-30° from the vertical x-z plane). For example, the paste filling unit and the pattern transfer sheet plane may be set at an angle deviating 0-30° from the vertical x-z plane.

PTP method **500** may further comprise delivering the wafers using two alternating stages, with each stage supporting two wafers (stage **532**), controllably delivering the wafers for the pattern transfer at a close proximity (e.g., in a range of between 0.1mm and 0.5mm) to the pattern transfer sheet (stage **534**) and carrying out the wafer measurement (before printing), pattern transfer onto a wafer (printing) and a print QC inspection (after printing) simultaneously for at least three of the wafers (stage **536**), wherein at least two of the wafers are supported by the same stage. The wafers are then advanced by consecutively moving the stage along CMD. The stages may be alternated following the printed wafers release to the output conveyor, parallelizing the printing process to increase throughput. In certain embodiments, only two wafers (e.g., positioned on the same stage) are processed simultaneously, alternating between (i) wafer alignment (before printing) and pattern transfer onto a wafer (printing), and (ii) pattern transfer onto a wafer (printing) and the print QC inspection (after printing) for the respective pair of wafers.

PTP method **500** may further comprise affixing and flattening the respective pattern transfer sheet during the pattern transfer (stage **542**). The PTP method (500) further comprises monitoring x,θ-positions and/or distortions of the trenches prior to the pattern transfer (stage **544**).

PTP method **500** may further comprise detecting and measuring features on the wafer and adjusting the pattern transfer accordingly (stage **546**).

PTP method **500** may further comprise inspecting the printing quality of the transferred paste pattern (stage **550**), e.g., by measuring an accuracy of the pattern transfer and/or detecting defects in the transferred pattern on the wafer

As illustrated in **Figure 9B****,** PTP method **500** may comprise method stages implemented by tape handling unit **200,** pattern transfer unit **350** and wafer handling unit **400,** as illustrated schematically and described in detail herein.

PTP method **500** may comprise moving pattern transfer sheets from the unwinder roll towards the paste filling unit (stage **510A**), the filling of the trenches with paste (stage **520**), moving the filled sheets to the pattern transfer unit (stage **510B**), e.g., stretching and affixing the filled sheets in the transfer unit (stage **542A**), as disclsoed herein. Following paste removal from the sheets, PTP method **500** may comprise moving the used sheets towards the re-use unit (stage **514**), cleaning and drying the sheets (stage **560A**) and moving the cleaned sheets toward the re-winding roll, possibly for future use (stage **560B**).

PTP method **500** may further comprise measuring the positions of the trenches by the trench alignment unit (stage **544A**), laser-scanning the trenches to transfer the paste to respective wafers **90** (stages **540A, 540B, 540C, 540D**), as provided by the wafer handling unit, until the trenches from the same sheet are laser-scanned onto the last provided wafer (stage **544B**).

PTP method **500** may further comprise handling the wafers using two stages **410A, 410B,** which carry out the following stages, respectively: putting wafers on the wafer holders from the input conveyor (stages **530A, 530B**), moving the wafers to the wafer alignment units (stages **532A, 532B**), determining the wafer positions of the wafer holders (stages **534A, 534B**), moving the wafer sequentially to the transfer printing unit, optionally during the printing of previous wafers (stages **535A, 535B** and stages **535C, 535D,** respectively for the two stages), and then moving the wafers to the print quality units (stages **550A, 550B**), followed by releasing the wafers to the output conveyor (stages **552A, 552B**) and returning the stages to their initial positions (stages **553A, 553B**) to repeat stages **530-553.**

Advantageously, disclosed PTP systems may be optimized to increase accuracy, efficiency and throughput by providing continuous handling of wafers during pattern transfer and using dual-chuck wafer stages, alignment of wafers by multiple cameras, more accurate alignment of transfer sheet by multiple cameras at the print position and locating the paste filling module at near vertical position thus reducing time between paste filling and pattern transfer.

**Figure 10** is a high-level block diagram of exemplary computing device **170,** which may be used with embodiments of the present invention. Computing device **170** may include a controller or processor **173** that may be or include, for example, one or more central processing unit processor(s) (CPU), one or more Graphics Processing Unit(s) (GPU or general-purpose GPU - GPGPU), a chip or any suitable computing or computational device, an operating system **171,** a memory **172,** a storage system **175,** input devices **176** and output devices **177.** PTP system **100,** control unit(s) **105,** any of processors **310, 425, 452** and/or parts thereof may be or include a computer system as shown for example in **Figure 10****.** The processors may comprise multiple cores configured to enable parallel processing of different tasks, for example processing of images of all the cameras of the wafer alignment unit or/and of the trench monitoring units or/and of the print quality units.

Operating system **171** may be or may include any code segment designed and/or configured to perform tasks involving coordination, scheduling, arbitration, supervising, controlling, or otherwise managing operation of computing device **170,** for example, scheduling execution of programs. Memory **172** may be or may include, for example, a Random-Access Memory (RAM), a read only memory (ROM), a Dynamic RAM (DRAM), a Synchronous DRAM (SD-RAM), a double data rate (DDR) memory chip, a Flash memory, a volatile memory, a non-volatile memory, a cache memory, a buffer, a short-term memory unit, a long-term memory unit, or other suitable memory units or storage units. Memory **172** may be or may include a plurality of possibly different memory units. Memory **172** may store for example, instructions to carry out a method (e.g., code **174**), and/or data such as user responses, interruptions, etc.

Executable code **174** may be any executable code, e.g., an application, a program, a process, task or script. Executable code **174** may be executed by processor **173** possibly under control of operating system **171.** For example, executable code **174** may when executed cause the production or compilation of computer code, or application execution such as VR execution or inference, according to embodiments of the present invention. Executable code **174** may be code produced by methods described herein. For the various modules and functions described herein, one or more computing devices **170** or components of computing device **170** may be used. Devices that include components similar or different to those included in computing device **170** may be used and may be connected to a network and used as a system. One or more processor(s) **173** may be configured to carry out embodiments of the present invention by for example executing software or code.

Storage system **175** may be or may include, for example, a hard disk drive, a floppy disk drive, a Compact Disk (CD) drive, a CD-Recordable (CD-R) drive, a universal serial bus (USB) device or other suitable removable and/or fixed storage unit. Data such as instructions, code, VR model data, parameters, etc. may be stored in a storage system **175** and may be loaded from storage system **175** into a memory **172** where it may be processed by processor **173.** In some embodiments, some of the components shown in **Figure 10** may be omitted.

Input devices **176** may be or may include for example a mouse, a keyboard, a touch screen or pad or any suitable input device. It will be recognized that any suitable number of input devices may be operatively connected to computing device **170** as shown by block **176.** Output devices **177** may include one or more displays, speakers and/or any other suitable output devices. It will be recognized that any suitable number of output devices may be operatively connected to computing device **170** as shown by block **177.** Any applicable input/output (I/O) devices may be connected to computing device **170,** for example, a wired or wireless network interface card (NIC), a modem, printer or facsimile machine, a universal serial bus (USB) device or external hard drive may be included in input devices **176** and/or output devices **177.**

Embodiments of the invention may include one or more article(s) (e.g., memory **172** or storage system **175**) such as a computer or processor non-transitory readable medium, or a computer or processor non-transitory storage medium, such as for example a memory, a disk drive, or a USB flash memory, encoding, including or storing instructions, e.g., computer-executable instructions, which, when executed by a processor or controller, carry out methods disclosed herein.

## Claims

1. A pattern transfer printing (PTP) system comprising:
a tape handling unit (200) configured to handle a tape (205) comprising, as sections thereof, a plurality of pattern transfer sheets (205A, 205B) having respective patterns of trenches (110, 220), and to controllably deliver the pattern transfer sheets (205A, 205B) for paste filling and consecutively for pattern transfer,
a paste filling unit (120) configured to fill the trenches (110, 220) on the delivered pattern transfer sheets (205A, 205B) with conductive printing paste,
a wafer handling unit (400) configured to controllably deliver at least one wafer (90) for the pattern transfer at a close proximity to the pattern transfer sheet (205A, 205B),
a paste transfer unit (350) configured to transfer the conductive printing paste from the pattern transfer sheets (205A, 205B) filled with the conductive printing paste onto the wafer (90) delivered in position, by releasing the conductive printing paste from the trenches (110, 220) upon illumination by a laser beam (80),
wherein the tape handling unit (200) is configured to move the tape (205) from an unwinder roll (222) to a re-winding roll (242) in a step-and-repeat mode,
**characterized in that** the pattern transfer printing (PTP) system further comprises:
a trench alignment monitoring unit (300) configured to monitor a position and a distortion of the trenches (110, 220) prior to the pattern transfer.

2. The PTP system of claim 1, wherein the tape handling unit (200) is further configured to deliver the pattern transfer sheets (205A, 205B) one-by-one for the paste filling and/or for the pattern transfer, wherein the tape handling unit (200) optionally further comprises at least one top dancer (225) and at least one bottom dancer (245) configured to maintain a tension of the tape (205) continuously.

3. The PTP system of claim 1 or 2, further comprising a tape re-use unit (250) configured to clean the pattern transfer sheets (205A, 205B) after the pattern transfer to provide reusable pattern transfer (205A, 205B) sheets and optionally comprising a pre-cleaning compartment (252A) for removing clumps of paste, a cleaning compartment (252B) configured to remove fine paste remains and a drying unit for drying the tape (205) before rewinding, wherein the tape re-use unit (250) optionally further comprises at least one dancer and/or rolls configured to maintain a tension of the tape (205) moving through the tape re-use unit (250).

4. The PTP system of any of claims 1-3, wherein the paste filling unit (120) comprises moveable paste filling head (122) and a countering moveable roll (125) configured to support a back side of the pattern transfer sheet (205A, 205B) during the paste filling.

5. The PTP system of any of claims 1-4, wherein the tape movement through the paste filling unit (120) is set at an angle in the range of 0-30° relative to the vertical axis, wherein the vertical axis is perpendicular to the tape movement through the wafer handling unit (400).

6. The PTP system of any of claims 1-5, wherein the wafer handling unit (400) comprises at least one stage enabling movement in machine direction along tape movement plane of the tape handling unit (200) and perpendicular to the tape movement plane of the tape handling unit (200), each of the at least one stage comprising at least one holder, with each of the holders supporting a corresponding wafer (90) and enabling wafer movement in the tape movement plane of the tape handling unit (200) and rotation of the wafer (90) around an axis that is perpendicular to the tape movement plane of the tape handling unity (200).

7. The PTP system of any of claims 1-6, wherein the paste transfer unit (350) is further configured to control the illumination of the paste-filled trenches (110, 220) on the transfer sheet (205A, 205B) by the laser beam (80), wherein the illumination of the paste-filled trenches (110, 220) is optionally done one-by-one by help of an optical head enabling fast laser scanning along tape movement plane of the tape handling unit (200) (in machine direction (MD) along the tape movement plane) and perpendicularly movable along the tape movement plane of the tape handling unit (200) (perpendicular to the machine direction (CMD)).

8. The PTP system of any of claims 1-7, further comprising a tape stretching unit (270) configured to affix and flatten the respective pattern transfer sheet (205A, 205B) during the pattern transfer.

9. The PTP system of any of claims 1-8, wherein the trench alignment monitoring unit (300) comprises multiple imaging cameras (285, 290) configured to capture ends of the trenches (110, 220) and at least two tilted imaging cameras (290) configured to capture at least middle-sections of the trenches (110, 220), wherein the tilt is configured to capture the middle-sections of the trenches (110, 220).

10. The PTP system of any of claims 1-9, further comprising a wafer alignment unit configured to detect and measure features on the wafer (90) and further adjust the wafer position in the paste transfer unit (350) accordingly, wherein the wafer alignment unit optionally comprises multiple imaging cameras configured to capture at least a part of a perimeter of the wafer (90), the cameras optionally configured to image the wafer corners and features at a middle of the wafer.

11. The PTP system of any of claims 1-10, further comprising a print quality control unit configured to detect defects of the transferred pattern on wafers (90).

12. A dual lane production line comprising two PTP systems of any of claims 1-10, comprising two parallel wafer flows, wherein the respective unwinder roll (222) and re-winding roll (242) of each of the PTP system are accessible for maintenance.

13. A pattern transfer printing (PTP) method comprising:
handling a tape (205) comprising, as sections thereof, a plurality of pattern transfer sheets (205A, 205B) having respective patterns of trenches (110, 220), to controllably deliver the pattern transfer sheets (205A, 205B) for paste filling and consecutively for pattern transfer,
filling the trenches (110, 220) on the delivered pattern transfer sheets (205A, 205B) with conductive printing paste,
controllably delivering a plurality of wafers (90) for the pattern transfer, and
monitoring positions and distortions of the trenches (110, 220) prior to the pattern transfer,
transferring the conductive printing paste from the pattern transfer sheets (205A, 205B) onto the delivered wafers (90), by releasing the printing paste from the trenches (110, 220) upon illumination by a laser beam (80),
wherein the handling of the tape (205) comprises moving the tape (205) from an unwinder roll (222) to a re-winding roll (242) in a step-and-repeat mode, and optionally comprising at least one of:
monitoring a tension and a position of the tape (205),
cleaning the pattern transfer sheets (205A, 205B) after the pattern transfer to provide reusable pattern transfer sheets (205A, 205B),
supporting a back side of the pattern transfer sheet (205A, 205B) by a countering moveable roll during the paste filling,
affixing and flattening the pattern transfer sheet (205A, 205B) during the pattern transfer,
detecting and measuring features on the wafer (90) and adjusting accordingly the transferring of the conductive printing paste from the pattern transfer sheets (205A, 205B) onto the delivered wafers (90), and
inspecting a quality of the transferred paste pattern.

14. The PTP method of claim 13, further comprising carrying out the PTP method using two PTP systems in a dual lane production line, with parallel wafer delivery and with the tape (205) and the unwinder roll (222) and re-winding roll (242) accessible for replacement and maintenance from a front side of each of the PTP systems.

## Patentansprüche

1. Pattern-Transfer-Printing-System (PTP-System), umfassend:
eine Bandhandhabungseinheit (200), die dazu konfiguriert ist, ein Band (205) handzuhaben, umfassend eine Vielzahl von Pattern-Transfer-Platten (205A, 205B) mit jeweiligen Strukturen von Gräben (110, 220) als Abschnitte davon, und die Pattern-Transfer-Platten (205A, 205B) zum Pastenfüllen und anschließend zum Pattern Transfer (Strukturübertragung) steuerbar abzugeben,
eine Pastenfülleinheit (120), die dazu konfiguriert ist, die Gräben (110, 220) auf den abgegebenen Pattern-Transfer-Platten (205A, 205B) mit leitfähiger Druckpaste zu füllen,
eine Waferhandhabungseinheit (400), die dazu konfiguriert ist, mindestens einen Wafer (90) zum Pattern Transfer in unmittelbarer Nähe zu der Pattern-Transfer-Platte (205A, 205B) steuerbar abzugeben,
eine Pastenübertragungseinheit (350), die dazu konfiguriert ist, die leitfähige Druckpaste von den Pattern-Transfer-Platten (205A, 205B), die mit der leitfähigen Druckpaste gefüllt sind, durch Freisetzen der leitfähigen Druckpaste aus den Gräben (110, 220) bei Beleuchtung mit einem Laserstrahl (80) auf den in Position abgegebenen Wafer (90) zu übertragen,
wobei die Bandhandhabungseinheit (200) dazu konfiguriert ist, das Band (205) von einer Abwickelwalze (222) auf eine Umwickelwalze (242) in einem Step-and-Repeat-Modus zu bewegen,
**dadurch gekennzeichnet, dass** das Pattern-Transfer-Printing-System (PTP-System) ferner umfasst: eine Grabenausrichtungsüberwachungseinheit (300), die dazu konfiguriert ist, eine Position und eine Verwerfung der Gräben (110, 220) vor dem Pattern Transfer zu überwachen.

2. PTP-System nach Anspruch 1, wobei die Bandhandhabungseinheit (200) ferner dazu konfiguriert ist, die Pattern-Transfer-Platten (205A, 205B) nacheinander zum Pastenfüllen und/oder zum Pattern Transfer abzugeben, wobei die Bandhandhabungseinheit (200) optional ferner mindestens einen oberen Tänzer (225) und mindestens einen unteren Tänzer (245) umfasst, die dazu konfiguriert sind, eine Spannung des Bands (205) kontinuierlich aufrechtzuerhalten.

3. PTP-System nach Anspruch 1 oder 2, ferner umfassend eine Bandwiederverwendungseinheit (250), die dazu konfiguriert ist, die Pattern-Transfer-Platten (205A, 205B) nach dem Pattern Transfer zu reinigen, um wiederverwendbare Pattern-Transfer-Platten (205A, 205B) bereitzustellen, und optional umfassend eine Vorreinigungskammer (252A) zum Entfernen von Pastenklumpen, eine Reinigungskammer (252B), die dazu konfiguriert ist, feine Pastenrückstände zu entfernen, und eine Trocknungseinheit zum Trocknen des Bands (205) vor dem Umwickeln, wobei die Bandwiederverwendungseinheit (250) optional ferner mindestens einen Tänzer und/oder Walzen umfasst, die dazu konfiguriert sind, eine Spannung des Bands (205) aufrechtzuerhalten, das sich durch die Bandwiederverwendungseinheit (250) bewegt.

4. PTP-System nach einem der Ansprüche 1-3, wobei die Pastenfülleinheit (120) einen beweglichen Pastenfüllkopf (122) und eine entgegenwirkende bewegliche Walze (125) umfasst, die dazu konfiguriert ist, eine Rückseite der Pattern-Transfer-Platte (205A, 205B) während des Pastenfüllens zu tragen.

5. PTP-System nach einem der Ansprüche 1-4, wobei die Bandbewegung durch die Pastenfülleinheit (120) auf einen Winkel im Bereich von 0-30° in Bezug auf die vertikale Achse eingestellt ist, wobei die vertikale Achse senkrecht zu der Bandbewegung durch die Waferhandhabungseinheit (400) ist.

6. PTP-System nach einem der Ansprüche 1-5, wobei die Waferhandhabungseinheit (400) mindestens eine Stufe umfasst, die eine Bewegung in Maschinenrichtung entlang einer Bandbewegungsebene der Bandhandhabungseinheit (200) und senkrecht zu der Bandbewegungsebene der Bandhandhabungseinheit (200) ermöglicht, wobei jede der mindestens einen Stufe mindestens eine Halterung umfasst, wobei jede der Halterungen einen entsprechenden Wafer (90) trägt und eine Waferbewegung in der Bandbewegungsebene der Bandhandhabungseinheit (200) und eine Drehung des Wafers (90) um eine Achse ermöglicht, die senkrecht zu der Bandbewegungsebene der Bandhandhabungseinheit (200) ist.

7. PTP-System nach einem der Ansprüche 1-6, wobei die Pastenübertragungseinheit (350) ferner dazu konfiguriert ist, die Beleuchtung der mit Paste gefüllten Gräben (110, 220) auf der Übertragungsplatte (205A, 205B) durch den Laserstrahl (80) zu steuern, wobei die Beleuchtung der mit Paste gefüllten Gräben (110, 220) optional nacheinander mithilfe eines optischen Kopfs vorgenommen wird, der eine schnelle Laserabtastung entlang der Bandbewegungsebene der Bandhandhabungseinheit (200) (in Maschinenrichtung (MD) entlang der Bandbewegungsebene) und senkrecht beweglich entlang der Bandbewegungsebene der Bandhandhabungseinheit (200) (senkrecht zu der Maschinenrichtung (MD)) ermöglicht.

8. PTP-System nach einem der Ansprüche 1-7, ferner umfassend eine Banddehnungseinheit (270), die dazu konfiguriert ist, die jeweilige Pattern-Transfer-Platte (205A, 205B) während des Pattern Transfers zu fixieren und zu glätten.

9. PTP-System nach einem der Ansprüche 1-8, wobei die Grabenausrichtungsüberwachungseinheit (300) mehrere Bildgebungskameras (285, 290), die dazu konfiguriert sind, Enden der Gräben (110, 220) aufzunehmen, und mindestens zwei geneigte Bildgebungskameras (290) umfasst, die dazu konfiguriert sind, mindestens Mittelabschnitte der Gräben (110, 220) aufzunehmen, wobei die Neigung dazu konfiguriert ist, die Mittelabschnitte der Gräben (110, 220) aufzunehmen.

10. PTP-System nach einem der Ansprüche 1-9, ferner umfassend eine Waferausrichtungseinheit, die dazu konfiguriert ist, Merkmale auf dem Wafer (90) zu erkennen und zu messen und ferner die Position in der Pastenübertragungseinheit (350) entsprechend zu justieren, wobei die Waferausrichtungseinheit optional mehrere Bildgebungskameras umfasst, die dazu konfiguriert sind, mindestens einen Teil eines Umfangs des Wafers (90) aufzunehmen, wobei die Kameras optional dazu konfiguriert sind, die Waferecken und -merkmale an einer Mitte des Wafers abzubilden.

11. PTP-System nach einem der Ansprüche 1-10, ferner umfassend eine Druckqualitätskontrolleinheit, die dazu konfiguriert ist, Defekte der übertragenen Struktur auf Wafern (90) zu erkennen.

12. Zweibahnige Produktionsstraße, umfassend zwei PTP-Systeme nach einem der Ansprüche 1-10, umfassend zwei parallele Wafer-Durchläufe, wobei die jeweilige Abwickelwalze (222) und Umwickelwalze (242) jedes der PTP-Systeme für eine Wartung zugänglich sind.

13. Pattern-Transfer-Printing-Verfahren (PTP-Verfahren), umfassend:
Handhaben eines Bands (205), umfassend eine Vielzahl von Pattern-Transfer-Platten (205A, 205B) mit jeweiligen Strukturen von Gräben (110, 220) als Abschnitte davon, um die Pattern-Transfer-Platten (205A, 205B) zum Pastenfüllen und anschließend zum Pattern Transfer (Strukturübertragung) steuerbar abzugeben,
Füllen der Gräben (110, 220) auf den abgegebenen Pattern-Transfer-Platten (205A, 205B) mit leitfähiger Druckpaste,
steuerbares Abgeben einer Vielzahl von Wafern (90) zum Pattern Transfer, und
Überwachen von Positionen und Verwerfungen der Gräben (110, 220) vor dem Pattern Transfer,
Übertragen der leitfähigen Druckpaste von den Pattern-Transfer-Platten (205A, 205B) durch Freisetzen der Druckpaste aus den Gräben (110, 220) bei Beleuchtung mit einem Laserstrahl (80) auf die abgegebenen Wafer (90),
wobei das Handhaben des Bands (205) ein Bewegen des Bands (205) von einer Abwickelwalze (222) auf eine Umwickelwalze (242) in einem Step-and-Repeat-Modus umfasst, und optional umfassend mindestens eines von:
Überwachen einer Spannung und einer Position des Bands (205),
Reinigen der Pattern-Transfer-Platten (205A, 205B) nach dem Pattern Transfer, um wiederverwendbare Pattern-Transfer-Platten (205A, 205B) bereitzustellen,
Tragen einer Rückseite der Pattern-Transfer-Platte (205A, 205B) durch eine entgegenwirkende bewegliche Walze während des Pastenfüllens,
Fixieren und Glätten der Pattern-Transfer-Platte (205A, 205B) während des Pattern Transfers,
Erkennen und Messen von Merkmalen auf dem Wafer (90) und entsprechendes Justieren des Übertragens der leitfähigen Druckpaste von den Pattern-Transfer-Platten (205A, 205B) auf die abgegebenen Wafer (90), und
Prüfen einer Qualität der übertragenen Pastenstruktur.

14. PTP-Verfahren nach Anspruch 13, ferner umfassend ein Ausführen des PTP-Verfahrens unter Verwendung von zwei PTP-Systemen in einer zweibahnigen Produktionsstraße mit paralleler Waferabgabe und mit dem Band (205) und der Abwickelwalze (222) und der Umwickelwalze (242), die zum Austausch und zur Wartung von einer Vorderseite jedes der PTP-Systeme zugänglich sind.

## Revendications

1. Système d'impression par transfert de motifs (PTP) comprenant :
une unité de manipulation de bande (200) configurée pour manipuler une bande (205) comprenant, en tant que sections de celle-ci, une pluralité de feuilles de transfert de motifs (205A, 205B) comportant des motifs respectifs de tranchées (110, 220), et pour livrer de manière contrôlable les feuilles de transfert de motifs (205A, 205B) pour le remplissage par pâte et, consécutivement, pour le transfert de motifs,
une unité de remplissage par pâte (120) configurée pour remplir les tranchées (110, 220) sur les feuilles de transfert de motifs livrées (205A, 205B) avec une pâte d'impression conductrice,
une unité de manipulation de plaquette (400) configurée pour livrer de manière contrôlable au moins une plaquette (90) pour le transfert de motifs à une proximité immédiate de la feuille de transfert de motifs (205A, 205B),
une unité de transfert de pâte (350) configurée pour transférer la pâte d'impression conductrice depuis les feuilles de transfert de motifs (205A, 205B) remplies par la pâte d'impression conductrice jusque sur la plaquette (90) livrée en position, en libérant la pâte d'impression conductrice des tranchées (110, 220) lors de l'illumination par un faisceau laser (80),
où l'unité de manipulation de bande (200) est configurée pour déplacer la bande (205) d'un rouleau dérouleur (222) vers un rouleau de ré-enroulement (242) dans un mode pas à pas répétitif,
**caractérisé en ce que** le système d'impression par transfert de motifs (PTP) comprend en outre :
une unité de surveillance d'alignement de tranchées (300) configurée pour surveiller une position et une distorsion des tranchées (110, 220) avant le transfert de motifs.

2. Système PTP selon la revendication 1, où l'unité de manipulation de bande (200) est en outre configurée pour livrer les feuilles de transfert de motifs (205A, 205B) une par une pour le remplissage par pâte et/ou pour le transfert de motifs, où l'unité de manipulation de bande (200) comprend en outre éventuellement au moins un danseur supérieur (225) et au moins un danseur inférieur (245) configurés pour maintenir une tension de la bande (205) de manière continue.

3. Système PTP selon la revendication 1 ou 2, comprenant en outre une unité de réutilisation de bande (250) configurée pour nettoyer les feuilles de transfert de motifs (205A, 205B) après le transfert de motifs afin de fournir des feuilles de transfert de motifs (205A, 205B) réutilisables et comprenant éventuellement un compartiment de pré-nettoyage (252A) pour éliminer les amas de pâte, un compartiment de nettoyage (252B) configuré pour éliminer les résidus de pâte fins et une unité de séchage pour sécher la bande (205) avant le ré-enroulement, où l'unité de réutilisation de bande (250) comprend éventuellement en outre au moins un danseur et/ou des rouleaux configurés pour maintenir une tension de la bande (205) se déplaçant à travers l'unité de réutilisation de bande (250).

4. Système PTP selon l'une quelconque des revendications 1 à 3, où l'unité de remplissage par pâte (120) comprend une tête de remplissage par pâte mobile (122) et un rouleau mobile de contre-pression (125) configuré pour soutenir un côté arrière de la feuille de transfert de motifs (205A, 205B) pendant le remplissage par pâte.

5. Système PTP selon l'une quelconque des revendications 1 à 4, où le déplacement de la bande à travers l'unité de remplissage par pâte (120) est réglé à un angle dans la plage de 0 à 30° par rapport à l'axe vertical, l'axe vertical étant perpendiculaire au déplacement de la bande à travers l'unité de manipulation de plaquette (400).

6. Système PTP selon l'une quelconque des revendications 1 à 5, où l'unité de manipulation de plaquette (400) comprend au moins un étage permettant un mouvement dans le sens machine le long du plan de déplacement de la bande de l'unité de manipulation de bande (200) et perpendiculairement au plan de déplacement de la bande de l'unité de manipulation de bande (200), chacun des au moins un étage comprenant au moins un support, chacun des supports soutenant une plaquette correspondante (90) et permettant le déplacement de la plaquette dans le plan de déplacement de la bande de l'unité de manipulation de bande (200) et la rotation de la plaquette (90) autour d'un axe qui est perpendiculaire au plan de déplacement de la bande de l'unité de manipulation de bande (200).

7. Système PTP selon l'une quelconque des revendications 1 à 6, où l'unité de transfert de pâte (350) est en outre configurée pour contrôler l'illumination des tranchées remplies de pâte (110, 220) sur la feuille de transfert (205A, 205B) par le faisceau laser (80), où l'illumination des tranchées remplies de pâte (110, 220) est éventuellement effectuée une par une à l'aide d'une tête optique permettant un balayage laser rapide le long du plan de déplacement de la bande de l'unité de manipulation de bande (200) (dans le sens machine (MD) le long du plan de déplacement de la bande) et mobile perpendiculairement le long du plan de déplacement de la bande de l'unité de manipulation de bande (200) (perpendiculairement au sens machine (CMD)).

8. Système PTP selon l'une quelconque des revendications 1 à 7, comprenant en outre une unité d'étirement de bande (270) configurée pour fixer et aplatir la feuille de transfert de motifs respective (205A, 205B) pendant le transfert de motifs.

9. Système PTP selon l'une quelconque des revendications 1 à 8, où l'unité de surveillance d'alignement de tranchées (300) comprend plusieurs caméras d'imagerie (285, 290) configurées pour capturer les extrémités des tranchées (110, 220) et au moins deux caméras d'imagerie inclinées (290) configurées pour capturer au moins les sections de milieu des tranchées (110, 220), où l'inclinaison est configurée pour capturer les sections de milieu des tranchées (110, 220).

10. Système PTP selon l'une quelconque des revendications 1 à 9, comprenant en outre une unité d'alignement de plaquette configurée pour détecter et mesurer des caractéristiques sur la plaquette (90) et ajuster en outre la position de la plaquette dans l'unité de transfert de pâte (350) en conséquence, où l'unité d'alignement de plaquette comprend éventuellement plusieurs caméras d'imagerie configurées pour capturer au moins une partie d'un périmètre de la plaquette (90), les caméras étant éventuellement configurées pour imager les coins de la plaquette et les caractéristiques au niveau d'un milieu de la plaquette.

11. Système PTP selon l'une quelconque des revendications 1 à 10, comprenant en outre une unité de contrôle de qualité d'impression configurée pour détecter des défauts du motif transféré sur les plaquettes (90).

12. Ligne de production à double voie comprenant deux systèmes PTP selon l'une quelconque des revendications 1 à 10, comprenant deux flux de plaquettes parallèles, où le rouleau dérouleur (222) et le rouleau de ré-enroulement (242) respectifs de chacun des systèmes PTP sont accessibles pour la maintenance.

13. Procédé d'impression par transfert de motifs (PTP) comprenant :
la manipulation d'une bande (205) comprenant, en tant que sections de celle-ci, une pluralité de feuilles de transfert de motifs (205A, 205B) ayant des motifs respectifs de tranchées (110, 220), pour livrer de manière contrôlable les feuilles de transfert de motifs (205A, 205B) pour le remplissage par pâte et, consécutivement, pour le transfert de motifs,
le remplissage des tranchées (110, 220) sur les feuilles de transfert de motifs livrées (205A, 205B) avec une pâte d'impression conductrice,
la livraison contrôlable d'une pluralité de plaquettes (90) pour le transfert de motifs, et
la surveillance des positions et des distorsions des tranchées (110, 220) avant le transfert de motifs,
le transfert de la pâte d'impression conductrice des feuilles de transfert de motifs (205A, 205B) sur les plaquettes (90) livrées, en libérant la pâte d'impression des tranchées (110, 220) lors de l'illumination par un faisceau laser (80),
où la manipulation de la bande (205) comprend le déplacement de la bande (205) d'un rouleau dérouleur (222) vers un rouleau de ré-enroulement (242) dans un mode pas-à-pas répétitif, et comprend éventuellement au moins l'une des opérations suivantes :
la surveillance d'une tension et d'une position de la bande (205),
le nettoyage des feuilles de transfert de motifs (205A, 205B) après le transfert de motifs afin de fournir des feuilles de transfert de motifs (205A, 205B) réutilisables,
le soutien d'un côté arrière de la feuille de transfert de motifs (205A, 205B) par un rouleau mobile de contre-pression pendant le remplissage par pâte,
la fixation et l'aplatissement de la feuille de transfert de motifs (205A, 205B) pendant le transfert de motifs,
la détection et la mesure de caractéristiques sur la plaquette (90) et l'ajustement en conséquence du transfert de la pâte d'impression conductrice depuis les feuilles de transfert de motifs (205A, 205B) jusque sur les plaquettes livrées (90), et
l'inspection d'une qualité du motif de pâte transféré.

14. Procédé PTP selon la revendication 13, comprenant en outre la mise en œuvre du procédé PTP en utilisant deux systèmes PTP dans une ligne de production à double voie, avec une livraison parallèle des plaquettes et avec la bande (205) et le rouleau dérouleur (222) et le rouleau de ré-enroulement (242) accessibles pour le remplacement et la maintenance depuis un côté avant de chacun des systèmes PTP.
